# EUROPEAN PATENT APPLICATION

(11) **EP 4 804 190 A1**
(43) Date of publication of application: **09.09.2026**
(21) Application number: 26150155.5
(22) Date of filing: 05.01.2026
(51) Int. Cl.: G11C 7/10, G11C 16/26

(54) **NONVOLATILE MEMORY DEVICE INCLUDING CACHE LATCH ADDRESS INFORMATION AND/OR INPUT/OUTPUT PAD ADDRESS INFORMATION AND METHOD OF OPERATING THE SAME**

(30) Priority: 10.01.2025 KR 20250004151
(71) Applicant: Samsung Electronics Co., Ltd., Suwon-si, Gyeonggi-do 16677 (KR)
(72) Inventor: SONG, Seunghwan, 16677 Suwon-si, Gyeonggi-do (KR); KIM, Wandong, 16677 Suwon-si, Gyeonggi-do (KR); SONG, Kiwhan, 16677 Suwon-si, Gyeonggi-do (KR); JEONG, Youngseok, 16677 Suwon-si, Gyeonggi-do (KR); CHOI, Youngha, 16677 Suwon-si, Gyeonggi-do (KR); SONG, Seongjin, 16677 Suwon-si, Gyeonggi-do (KR); YUN, Sewon, 16677 Suwon-si, Gyeonggi-do (KR)
(74) Representative: Kuhnen & Wacker Patent- und Rechtsanwaltsbüro PartG mbB

(57) **Abstract**

A nonvolatile memory device (11A) includes a memory cell array including a plurality of planes (PLN1-PLNn), a page buffer circuit (PBC) connected to the memory cell array through a plurality of bitlines and comprising at least one cache latch, and a plurality of input/output pads (DQ1-DQk) connected to the page buffer circuit through a plurality of data lines and configured to transmit data to and receive data from a memory controller (12A). A command set may include at least one of cache latch address information or input/output pad address information, and the nonvolatile memory device is configured to perform a readout operation or a write operation based on at least one of the cache latch address information or the input/output pad address information included in the command set.

## Description

### BACKGROUND

The present disclosure relates to a nonvolatile memory device and a method of operating the same.

Semiconductor memory devices may be classified into volatile memory devices and nonvolatile memory devices. Volatile memory devices offer high read and write speeds but lose their stored data when their power supplies are interrupted. In contrast, nonvolatile memory devices retain their stored data even when their power supplies are interrupted. Therefore, nonvolatile memory devices are used to store data that should be preserved regardless of power supply.

A prime example of nonvolatile memory devices is a flash memory device. Flash memory devices are widely used as a storage medium for audio and video data in information devices such as computers, mobile phones, smartphones, personal digital assistants (PDAs), digital cameras, camcorders, voice recorders, MP3 players, handheld personal computers (PCs), game consoles, fax machines, scanners, or printers. As more information devices adopt nonvolatile memory for storage, there is growing demand for improved data input/output performance

### SUMMARY

The present disclosure provides a nonvolatile memory device configured to provide improved data input/output performance.

According to an embodiment, a nonvolatile memory device includes a memory cell array including a plurality of planes, a page buffer circuit connected to the memory cell array through a plurality of bitlines and comprising at least one cache latch, and a plurality of input/output pads connected to the page buffer circuit through a plurality of data lines and configured to transmit data to and receive data from a memory controller. A command set may include at least one of cache latch address information or input/output pad address information, and the nonvolatile memory device is configured to perform a readout operation or a write operation based on at least one of the cache latch address information or the input/output pad address information included in the command set.

At least one command address pad may receive the cache latch address information or the input/output pad address information included in the command set.

The page buffer circuit may comprise a plurality of page buffers corresponding to the plurality of bitlines; and each of the plurality of page buffers comprises: a first cache latch connected to a first data line among the plurality of data lines; and a second cache latch connected to a second data line among the plurality of data lines.

The plurality of input/output pads may comprise a first input/output pad and a second input/output pad; the first input/output pad corresponds to the first cache latch included in each of the plurality of page buffers; and the second input/output pad corresponds to the second cache latch included in each of the plurality of page buffers.

The plurality of planes may comprise a first plane and a second plane, the nonvolatile memory device configured such that: during the readout operation, the first input/output pad receives data from the first cache latch included in page buffers corresponding to the first plane among the plurality of page buffers, and the second input/output pad receives data from the second cache latch included in page buffers corresponding to the second plane among the plurality of page buffers; and during the write operation, the first input/output pad transmits data to the first cache latch included in the page buffers corresponding to the first plane among the plurality of page buffers, and the second input/output pad transmits data to the second cache latch included in the page buffers corresponding to the second plane among the plurality of page buffers.

The plurality of input/output pads may comprise a first input/output pad and a second input/output pad; and each of the first input/output pad and the second input/output pad selectively corresponds to one of the first cache latch and the second cache latch included in each of the plurality of page buffers.

The nonvolatile memory device is configured such that: during the readout operation or the write operation, the first input/output pad and the second input/output pad correspond to different planes, respectively.

The plurality of planes may comprise a first plane and a second plane; and configured such that: during the readout operation or the write operation, the first input/output pad is connected to the first cache latches included in page buffers corresponding to the first plane among the plurality of page buffers, and the second input/output pad is connected to the second cache latches included in page buffers corresponding to the second plane among the plurality of page buffers.

The nonvolatile memory device may further comprise: a shared cache latch connected to one of the plurality of data lines.

The page buffer circuit may comprise: a first page buffer corresponding to a first bitline among the plurality of bitlines; and a second page buffer corresponding to a second bitline among the plurality of bitlines; the first page buffer comprises a first cache latch connected to a first data line among the plurality of data lines; the second page buffer comprises a second cache latch connected to a second data line among the plurality of data lines; and the first page buffer and the second page buffer are selectively connected to the shared cache latch based on the cache latch address.

The plurality of input/output pads may comprise a first input/output pad and a second input/output pad; the first input/output pad corresponds to the first cache latch included in the first page buffer and a second cache latch included in the second page buffer; and the second input/output pad corresponds to the shared cache latch.

The plurality of planes may comprise a first plane and a second plane; the first page buffer corresponds to the first plane, and the second page buffer corresponds to the second plane; and during the readout operation or the write operation, a first input/output pad transmits data to and receives data from the first cache latch included in the first page buffer, and a second input/output pad transmits data to and receives data from the shared cache latch connected to the second page buffer.

The plurality of input/output pads may comprise a first input/output pad and a second input/output pad; the first input/output pad corresponds to planes included in a first plane group among the plurality of planes; and the second input/output pad corresponds to planes included in a second plane group among the plurality of planes.

The page buffer circuit may comprise a first sub-page buffer group and a second sub-page buffer group; the first sub-page buffer group and the second sub-page buffer group correspond to the same plane among the plurality of planes and each comprise a plurality of page buffers; each of the page buffers included in the first sub-page buffer group comprises: a first cache latch; and a second cache latch connected to a data line different from a data line of the first cache latch; and each of the page buffers included in the second sub-page buffer group comprises: a third cache latch; and a fourth cache latch connected to a data line different from a data line of the third cache latch.

The plurality of input/output pads may comprise a first input/output pad and a second input/output pad; the first input/output pad corresponds to the first cache latch included in the first sub-page buffer group and the third cache latch included in the second sub-page buffer group; and the second input/output pad corresponds to the second cache latch included in the first sub-page buffer group and the fourth cache latch included in the second sub-page buffer group.

The nonvolatile memory device may be configured such that: during the readout operation or the write operation, the first input/output pad transmits data to and receives data from the first cache latch included in the first sub-page buffer group, and the second input/output pad transmits data to and receives data from the third cache latch included in the second sub-page buffer group.

The nonvolatile memory device may be configured such that: the page buffer circuit comprises a first cache latch and a second cache latch corresponding to a first plane among the plurality of planes; an operation of transferring data stored in the first plane to the first cache latch is performed during a first time period; an operation of transferring data stored in the first plane to an external entity through an input/output pad connected to the second cache latch, among the plurality of input/output pads, is performed during a second time period; and the first time period and the second time period at least partially overlap.

The nonvolatile memory device may be configured such that: the page buffer circuit comprises a data latch, a first cache latch, and a second cache latch corresponding to a first plane among the plurality of planes; an operation of moving data stored in the first cache latch to the data latch is performed during a first time period; an operation of transferring data to the second cache latch through an input/output pad connected to the second cache latch, among the plurality of input/output pads, is performed during a second time period; and the first time period and the second time period at least partially overlap.

The command set may comprise: a read command requesting a read operation for data stored in a target plane among the plurality of planes; and an address field comprising address information for the target plane; and at least one of the read command or the address field comprises at least one of the cache latch address information or the input/output pad address information.

The read command may be encoded to comprise the cache latch address information.

The command set may comprise: a data-out command requesting a data-out operation for data stored in a plurality of cache latches corresponding to a target plane among the plurality of planes; and an address field comprising address information for the target plane; and at least one of the data-out command or the address field comprises at least one of the cache latch address information or the input/output pad address information.

The address field may comprise the cache latch address information and the input/output pad address information.

The command set may comprise: a data-in command requesting a data-in operation for storing data in a plurality of cache latches corresponding to a target plane among the plurality of planes; and an address field comprising address information for the target plane; and at least one of the data-in command or the address field comprises at least one of the cache latch address information or the input/output pad address information.

The address field may comprise the cache latch address information and the input/output pad address information.

The command set may comprise: a data-in dump command requesting a data-in dump operation for moving data stored in a plurality of cache latches corresponding to a target plane, among the plurality of planes, to a selected data latch among a plurality of data latches; and an address field comprising address information for the selected data latch; and at least one of the data-in dump command or the address field comprises at least one of the cache latch address information or the input/output pad address information.

The data-in dump command may be encoded to comprise the cache latch address information. According to an embodiment, a method of operating a nonvolatile memory device includes receiving a command set requesting a readout operation and performing at least two readout operations in parallel based on at least one of cache latch address information or input/output pad address information included in the command set.

The command set may comprise a read command set requesting a read operation; the performing of the at least two readout operations in parallel comprises: sensing first data stored in a first plane among a plurality of planes; sensing second data stored in a second plane among the plurality of planes; storing the first data in a first cache latch corresponding to the first plane based on the cache latch address information; and storing the second data in a second cache latch corresponding to the second plane based on the cache latch address information; and the storing of the first data in the first cache latch and the storing of the second data in the second cache latch are performed in parallel.

The command set may further comprise a data-out command set requesting a data-out operation; the performing of the at least two readout operations in parallel further comprises: transmitting the first data stored in the first cache latch to an external entity through a first input/output pad; and transmitting the second data stored in the second cache latch to the external entity through a second input/output pad; and the transmitting of the first data through the first input/output pad and the transmitting of the second data through the second input/output pad are performed in parallel.

According to an embodiment, a method of operating a nonvolatile memory device includes receiving a command set requesting a write operation and performing at least two write operations in parallel based on at least one of cache latch address information or input/output pad address information included in the command set.

The method may comprise: receiving a command set requesting a write operation; and performing at least two write operations in parallel based on at least one of cache latch address information or input/output pad address information included in the command set.

The command set may comprise a data-in command set requesting a data-in operation, and the performing of the at least two write operations in parallel comprises: receiving first data to be stored in a first plane, among a plurality of planes, through a first input/output pad; receiving second data to be stored in a second plane, among the plurality of planes, through a second input/output pad; storing the first data received through the first input/output pad in a first cache latch corresponding to the first plane based on the cache latch address information and the input/output pad address information; and storing the second data received through the second input/output pad in a second cache latch corresponding to the second plane based on the cache latch address information and the input/output pad address information; and the storing of the first data in the first cache latch and the storing of the second data in the second cache latch are performed in parallel.

The command set may further comprise a data-in dump command set requesting a data-in dump operation; the performing of the at least two write operations in parallel further comprises: transmitting the first data stored in the first cache latch to a first data latch corresponding to the first plane based on the cache latch address information; and transmitting the second data stored in the second cache latch to a second data latch corresponding to the second plane based on the cache latch address information; and the transmitting of the first data to the first data latch and the transmitting of the second data to the second data latch are performed in parallel.

### BRIEF DESCRIPTION OF DRAWINGS

FIG. 1A is a block diagram illustrating a storage system according to one or more embodiments.
FIG. 1B is a block diagram illustrating a storage system according to one or more embodiments.
FIGS. 2A-2C are diagrams illustrating an example of a page buffer included in a page buffer circuit of FIG. 1.
FIGS. 3A and 3B are diagrams illustrating examples of a command set for a readout operation.
FIG. 4 is a flowchart illustrating a readout operation according to one or more embodiments.
FIGS. 5A and 5B are diagrams illustrating examples of command sets for a write operation.
FIG. 6 is a flowchart illustrating a write operation according to one or more embodiments.
FIGS. 7A and 7B are block diagrams illustrating memory controllers in greater detail according to one or more embodiments.
FIG. 8A is a block diagram illustrating a nonvolatile memory device in greater detail according to one or more embodiments.
FIG. 8B is a block diagram illustrating a nonvolatile memory device in greater detail according to one or more embodiments.
FIG. 9 is a circuit diagram illustrating a representative memory block selected from a plurality of memory blocks according to one or more embodiments.
FIGS. 10A-10C are block diagrams illustrating a page buffer according to one or more embodiments.
FIG. 11 is a diagram illustrating a correspondence relationship between an input/output pad and a cache latch of a nonvolatile memory device according to one or more embodiments.
FIG. 12 is a diagram illustrating a correspondence relationship between an input/output pad and a cache latch of a nonvolatile memory device according to one or more embodiments.
FIG. 13 is a diagram illustrating a correspondence relationship between an input/output pad and a cache latch of a nonvolatile memory device according to one or more embodiments.
FIG. 14 is a diagram illustrating a correspondence relationship between an input/output pad and a cache latch of a nonvolatile memory device according to one or more embodiments.
FIG. 15 is a diagram illustrating a correspondence relationship between an input/output pad and a cache latch of a nonvolatile memory device according to one or more embodiments.
FIGS. 16A and 16B are diagrams illustrating a command set for a readout operation in greater detail.
FIGS. 17A and 17B are diagrams illustrating a command set for a write operation in greater detail.
FIGS. 18A, 18B, 19, 20, and 21 are diagrams illustrating examples, in which readout operations and/or write operations are performed in parallel, in greater detail.
FIGS. 22A and 22B are flowcharts illustrating a readout operation according to one or more embodiments.
FIGS. 23A and 23B are flowcharts illustrating a write operation according to one or more embodiments.
FIGS. 24A, 24B, 25, and 26 are diagrams illustrating examples, in which readout operations and/or write operations are performed in parallel, in greater detail.
FIGS. 27A and 27B are flowcharts illustrating a readout operation in a single plane according to one or more embodiments.
FIGS. 28A and 28B are flowcharts illustrating a write operation in a single plane according to one or more embodiments.
FIGS. 29 and 30 are diagrams illustrating an example, in which a core operation is performed during a data-out operation, in greater detail.
FIGS. 31 and 32 are diagrams illustrating an example, in which a core operation is performed during a data-in operation, in greater detail.

### DETAILED DESCRIPTION

The following description with reference to the accompanying drawings is provided to assist in a comprehensive understanding of various embodiments.

### [Storage system performing readout operations and/or write operations in parallel based on input/output pad address and/or cache latch address]

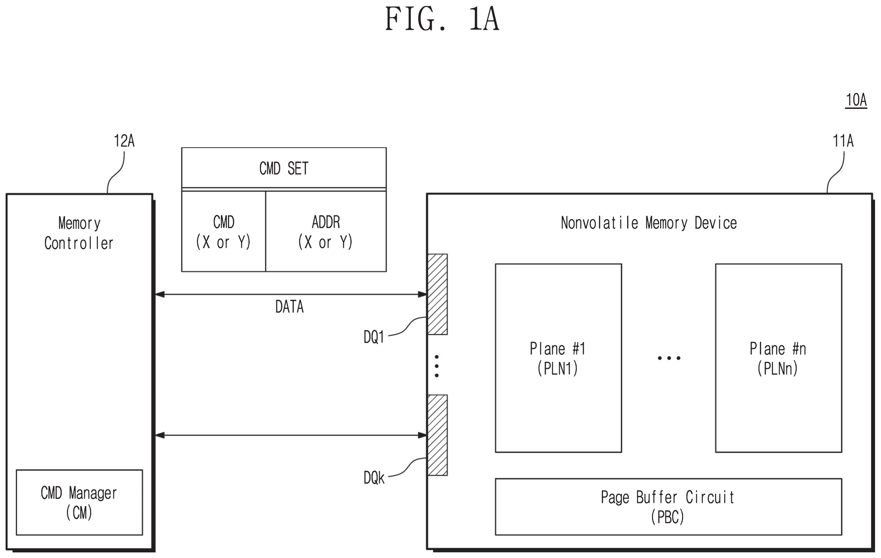

FIG. 1A is a block diagram illustrating a storage system 10A according to one or more embodiments.

The storage system 10A according to one or more embodiments includes a nonvolatile memory device 11A and a memory controller 12A. The nonvolatile memory device 11A may include a plurality of input/output pads. The nonvolatile memory device 11A may perform readout operations in parallel or write operations in parallel based on at least one of an input/output (I/O) pad address or a cache latch address received from the memory controller 12A, improving data input/output performance.

The nonvolatile memory device 11A may include a plurality of planes PLN1 to PLNn, a page buffer circuit PBC, and a plurality of input/output pads DQ1 to DQk.

The plurality of planes PLN1 to PLNn may store data. Each of the plurality of planes PLN1 to PLNn may include memory cells that store data.

For example, each of the plurality of planes PLN1 to PLNn may include a nonvolatile memory such as a NAND flash memory. However, this is an example, and each of the plurality of planes PLN1 to PLNn may include a nonvolatile memory such as RRAM, MRAM, PRAM, or the like. Each plane PLN1 to PLNn may include the same number of memory cells, and may share at least some of the same addresses (e.g., row addresses), and each plane may be accessed and/or selected separately from other planes.

The page buffer circuit PBC may temporarily store data to be programmed into a selected plane among the plurality of planes PLN1 to PLNn or data read from a selected plane.

The page buffer circuit PBC may be connected to the plurality of planes PLN1 to PLNn through bitlines. For example, the page buffer circuit PBC may include a plurality of page buffers, and a single page buffer may correspond to a single bitline.

In addition, the page buffer circuit PBC may be connected to the plurality of input/output pads DQ1 to DQk through data lines. In addition, the page buffer circuit PBC may include a plurality of page buffers, and a single page buffer may correspond to at least one cache latch.

In one or more embodiments, a single page buffer may include at least two cache latches. The at least two cache latches may be connected to different input/output pads. Accordingly, data transmission paths may be formed in parallel during a readout operation or a write operation, improving data input/output performance.

Alternatively, in one or more embodiments, a single page buffer may include at least one cache latch, and a shared cache latch shared by different page buffers may be provided. A single page buffer may correspond to at least one cache latch and the shared cache latch, and the at least one cache latch and the shared cache latch may be connected to different input/output pads. Accordingly, data transmission paths may be formed in parallel during a readout operation or a write operation, improving data input/output performance.

Alternatively, in one or more embodiments, a single page buffer may include a single cache latch. Among the plurality of planes PLN1 to PLNn, two different planes may correspond to cache latches connected to different input/output pads. Accordingly, data transmission paths may be formed in parallel during a readout operation or a write operation, improving data input/output performance.

The plurality of input/output pads DQ1 to DQk may receive a command set CMD SET and/or data DATA from the memory controller 12A. Alternatively, the plurality of input/output pads DQ1 to DQk may transmit a command set CMD SET and/or data DATA to the memory controller 12A.

In one or more embodiments, data transmission or reception through the plurality of input/output pads DQ1 to DQk may be performed in parallel. For example, during transmission or reception of data through one of the plurality of input/output pads DQ1 to DQk, data may also be transmitted or received through another input/output pad. As a result, data input/output performance may be improved.

Alternatively, in one or more embodiments, while a data transmission or reception operation is performed through the plurality of input/output pads DQ1 to DQk, a core operation may be performed by the page buffer. The core operation may refer to an operation performed in the page buffer for a readout operation and/or a write operation. For example, when a single page buffer includes a first cache latch and a second cache latch, data sensed from a corresponding plane may be stored in a second cache latch while data stored in the first cache latch is transmitted through a corresponding input/output pad among the plurality of input/output pads DQ1 to DQk. As described above, a core operation may be performed while a data transmission and/or reception operation is performed through the plurality of input/output pads DQ1 to DQk, performing data input/output performance.

The memory controller 12A may request data input/output from the nonvolatile memory device 11A. To this end, the memory controller 12A may include a command manager CM.

The command manager CM may generate a command set CMD SET for requesting data input or output. For example, the command set CMD SET may include a command CMD and an address ADDR.

The command CMD may be, for example, either a readout command requesting data output or a write command requesting data input. However, this is an example, and embodiments are not limited thereto. According to one or more embodiments, the command CMD may be one of various commands defined in standards such as Joint Electron Device Engineering Council (JEDEC) or Open NAND Flash Interface (ONFI).

The address ADDR may include address information corresponding to the command CMD. For example, the address ADDR may include an address for at least one plane among the plurality of planes PLN1 to PLNn corresponding to the command CMD.

In one or more embodiments, at least one of the command CMD or the address ADDR may include at least one of a cache latch address or an input/output (I/O) pad address. For brevity, the cache latch address will be denoted as 'X,' and the input/output pad address will be denoted as 'Y.'

The cache latch address X may refer to address information on a selected cache latch among a plurality of cache latches. The input/output pad address Y may refer to address information on a selected input/output pad among the plurality of input/output pads DQ1 to DQk.

In one or more embodiments, the memory controller 12A may generate a command set CMD SET requesting data output. The nonvolatile memory device 11A may receive the command set CMD SET for data output from the memory controller 12A and perform a readout operation to read data DATA from at least one of the plurality of planes PLN1 to PLNn in response to the received command set CMD SET. The readout operation may include a read operation and a data-out operation.

For example, the memory controller 12A may generate a read command set. The nonvolatile memory device 11A may receive the read command set from the memory controller 12A and perform a read operation to sense data stored in at least one of the plurality of planes PLN1 to PLNn and move the sensed data to a cache latch in response to the received read command set.

For example, the memory controller 12A may generate a data-out command set. The nonvolatile memory device 11A may receive the data-out command set from the memory controller 12A and perform a data-out operation to transmit data stored in the cache latch to the memory controller 12A through an input/output pad in response to the received data-out command set.

At least one of the command CMD of the read command set, the address ADDR of the read command set, the command CMD of the data out command set, or the address ADDR of the data out command set may include at least one of a cache latch address X or an input/output pad address Y. Accordingly, readout operations on a plurality of planes or a single plane may be performed in parallel, improving data input/output performance.

In one or more embodiments, the memory controller 12A may generate a command set CMD SET requesting data input. The nonvolatile memory device 11A may receive the command set CMD SET for data input from the memory controller 12A and perform a write operation to store data DATA in at least one of the plurality of planes PLN1 to PLNn in response to the received command set CMD SET. The write operation may include a data-in operation and a data-in dump operation.

For example, the memory controller 12A may generate a data-in command set. The nonvolatile memory device 11A may receive the data-in command set from the memory controller 12A and perform a data in operation to move data received through an input/output pad to a cache latch in response to the received data-in command set.

For example, the memory controller 12A may generate a data-in dump command set. The nonvolatile memory device 11A may receive the data-in dump command set from the memory controller 12A and perform a data in dump operation to transmit data stored in the cache latch to a data latch in response to the received data-in dump command set.

At least one of the command CMD of the data-in command set, the address ADDR of the data-in command set, the command CMD of the data-in dump command set, or the address ADDR of the data-in dump command set may include a cache latch address X and/or an input/output pad address Y. Accordingly, write operations on a plurality of planes or a single plane may be performed in parallel, improving data input/output performance.

As described above, the storage system 10A according to one or more embodiments may perform readout operations or write operations in parallel based on at least one of an input/output pad address or a cache latch address, improving data input/output performance.

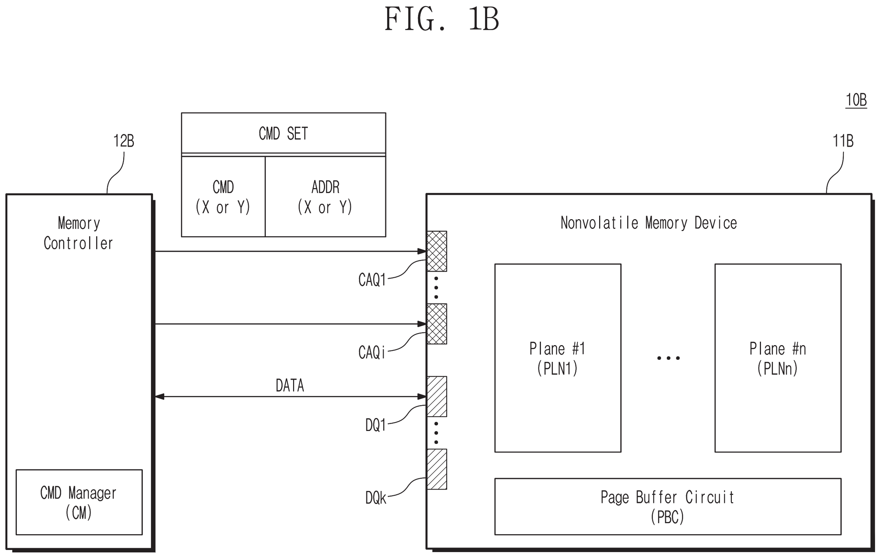

FIG. 1B is a block diagram illustrating a storage system 10B according to one or more embodiments. The storage system 10B of FIG. 1B is similar to the storage system 10A of FIG. 1A. Therefore, the same or substantially the same components are denoted by the same or substantially the same reference numerals, and redundant descriptions will be omitted.

Referring to FIG. 1B, the storage system 10B may include a nonvolatile memory device 11B and a memory controller 12B.

The nonvolatile memory device 11B may include at least one command address pad (hereinafter, CA pad CAQ1 to CAQi). The nonvolatile memory device 11B may receive or transmit a command set CMD SET through at least one CA pad CAQ1 to CAQi.

For example, the nonvolatile memory device 11B may receive a read command set or a data-out command set for data output through the at least one CA pad CAQ1 to CAQi. Alternatively, for example, the nonvolatile memory device 11B may receive a data-in command set or a data-in dump command set for data input through the at least one CA pad CAQ1 to CAQi.

The nonvolatile memory device 11B may include a plurality of input/output pads DQ1 to DQk. The nonvolatile memory device 11B may receive or transmit data DATA through the plurality of input/output pads DQ1 to DQk.

For example, the nonvolatile memory device 11B may transmit data corresponding to a command set CMD SET for data output to the memory controller 12B through a selected input/output pad among the plurality of input/output pads DQ1 to DQk. Alternatively, for example, the nonvolatile memory device 11B may receive data corresponding to a command set CMD SET for data input from the memory controller 12B through a selected input/output pad among the plurality of input/output pads DQ1 to DQk.

As described above, the storage system 10B according to one or more embodiments may include at least one CA pad CAQ1 to CAQi and a plurality of input/output pads DQ1 to DQk. A command set CMD SET may be received through at least one CA pad CAQ1 to CAQi, and data DATA may be received or transmitted through a selected input/output pad among the plurality of input/output pads DQ1 to DQk.

The data input/output operations according to one or more embodiments may reduce command-address overhead by separating the transmission paths of the command set CMD SET and data DATA. As a result, data input/output performance may be further improved.

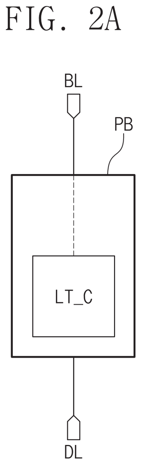

FIGS. 2A-2C are diagrams illustrating an example of a page buffer included in the page buffer circuit PBC of FIG. 1A. For clarity, an example of at least one cache latch corresponding to each page buffer is illustrated in FIGS. 2A-2C.

Referring to FIG. 2A, a page buffer PB according to one or more embodiments may include a single cache latch LT_C. The cache latch LT_C may be connected to a data line DL.

Data transmitted through a bitline BL may be temporarily stored in the cache latch LT_C during a readout operation. Then, the data stored in the cache latch LT_C may be transmitted to a selected input/output pad, among the plurality of input/output pads DQ1 to DQk (see FIG. 1A), through the data line DL.

Alternatively, data transmitted through the data line DL may be temporarily stored in the cache latch LT_C during a write operation. Then, the data stored in the cache latch LT_C may be programmed into a corresponding memory cell through the bitline BL.

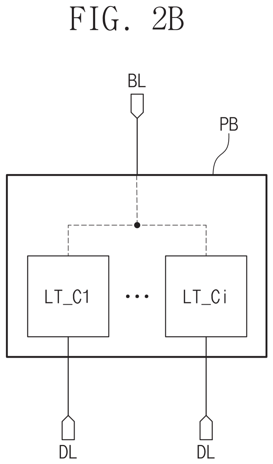

Referring to FIG. 2B, a page buffer PB according to one or more embodiments may include a plurality of cache latches LT_C1 to LT_Ci. Each of the plurality of cache latches LT_C1 to LT_Ci may be connected to a corresponding data line. The data lines may be connected to a plurality of input/output pads DQ1 to DQk. For example, the data lines may be connected to different input/output pads. However, this is an example, and the data lines may be connected to the same input/output pad according to embodiments.

Data transmitted through a bitline BL may be temporarily stored in a selected cache latch, among the plurality of cache latches LT_C1 to LT_Ci, during a readout operation. Then, the data stored in the selected cache latch may be transmitted to a selected input/output pad, among the plurality of input/output pads DQ1 to DQk, through the data line.

Alternatively, a cache latch among the plurality of cache latches LT_C1 to LT_Ci may be selected during a write operation. Data may be transmitted to the selected cache latch through the data line and temporarily stored in the selected cache latch. Then, the data stored in the selected cache latch may be programmed into a corresponding memory cell through a bitline BL.

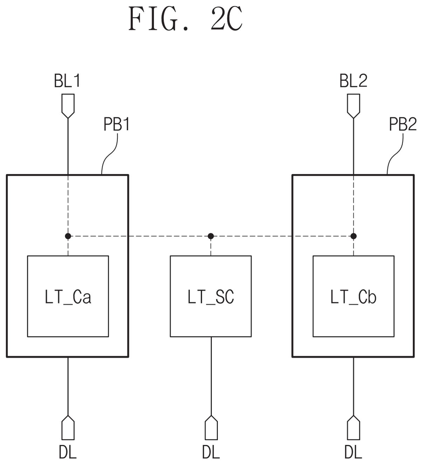

Referring to FIG. 2C, page buffers according to one or more embodiments may be provided with a shared cache latch LT_SC. For example, the page buffers may share at least one cache latch.

For example, a first page buffer PB1 and a second page buffer PB2 may each include a single cache latch and share a single shared cache latch LT_SC.

Data transmitted to the first page buffer PB1 through a first bitline BL1 may be temporarily stored in a selected cache latch, among the cache latch LT_Ca or the shared cache latch LT_SC, during a readout operation. Then, the data stored in the selected cache latch may be transmitted to a selected input/output pad, among the plurality of input/output pads DQ1 to DQk, through a corresponding data line. Similarly, data transmitted to the second page buffer PB2 through a second bitline BL2 may be temporarily stored in a selected cache latch, among the cache latch LT_Cb or the shared cache latch LT_SC, during the readout operation.

Alternatively, during a write operation, either a cache latch LT_Ca or the shared cache latch LT_SC corresponding to the first page buffer PB1 may be selected, and data transmitted through a data line may be temporarily stored in the selected cache latch. Then, the data stored in the selected cache latch may be programmed into a corresponding memory cell through the first bitline BL1. Similarly, during a write operation, either the cache latch LT_Cb or the shared cache latch LT_SC corresponding to the second page buffer PB2 may be selected, and data transmitted through a data line may be temporarily stored in the selected cache latch.

In FIG. 2C, the first page buffer PB1 and the second page buffer PB2 each have been described as including a single cache latch and sharing a single shared cache latch LT_SC. However, this is an example, and the number of cache latches included in each page buffer and the number of shared cache latches are not limited thereto.

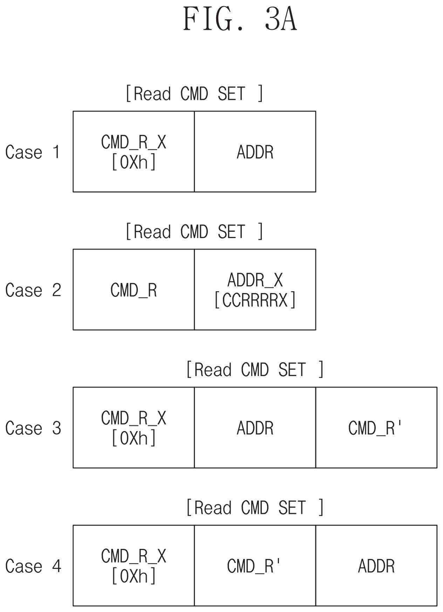

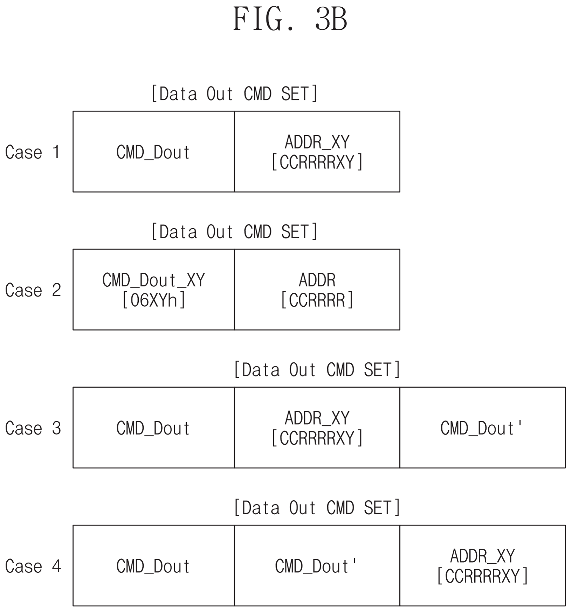

FIGS. 3A and 3B are diagrams illustrating examples of command sets for a readout operation. FIG. 3A is a diagram illustrating examples of a read command set, and FIG. 3B is a diagram illustrating examples of a data-out command set.

Referring to FIG. 3A, a read command set Read CMD SET may include at least one command and an address for a target plane on which a read operation is to be performed. According to one or more embodiments, at least one of the command or the address may include cache latch address information.

In one or more embodiments, as illustrated in the first case, the read command set Read CMD SET may include a read command CMD_R_X and an address ADDR. The read command CMD_R_X may include cache latch address information. For example, the read command CMD_R_X may be a command encoded to include cache latch address information.

For example, the read command CMD_R_X may be '0Xh,' where X is cache latch address information. At least one cache latch, among a plurality of cache latches, may be selected based on a value of X.

An illustrative example is provided for clarity, where page buffers corresponding to the target plane each include a first cache latch and a second cache latch. For example, when the value of X is 1, the first cache latch of each page buffer may be selected. For example, when the value of X is 2, the second cache latch of each page buffer may be selected. For example, when the value of X is 3, the first cache latch may be selected in a portion of the page buffers (e.g., a first set of page buffers) of the target plane, and the second cache latch may be selected in the remaining page buffers (e.g., a second set of page buffers). However, this is an example, and cache latch address information and the cache latches selected based on the cache latch address information may be configured in various ways according to embodiments.

In one or more embodiments, as illustrated in the second case, the read command set Read CMD SET may include a read command CMD_R and an address ADDR_X. The address ADDR_X may include cache latch address information. For example, the address ADDR_X may include not only address information on the target plane but also cache latch address information.

For example, the address ADDR_X may be 'CCRRRRX,' where CCRRRR is column address and row address information on the target plane, and X is cache latch address information. At least one cache latch, among a plurality of cache latches, may be selected based on a value of X.

In one or more embodiments, as illustrated in the third and fourth cases, the read command set Read CMD SET may include a plurality of read commands CMD_R_X and CMD_R' and an address ADDR_X. The order of the plurality of read commands CMD_R_X and CMD_R' and the address ADDR_X may be configured in various ways.

For example, as in the third case, the read command set Read CMD SET may be configured in the order of command CMD_R_X, address ADDR, and command CMD_R'. For example, as in the fourth case, the read command set Read CMD SET may be configured in the order of command CMD_R_X, command CMD_R', and address ADDR. However, this is an example, and the number and order of commands and addresses may be configured in various ways according to embodiments.

Referring to FIG. 3B, a data-out command set Data Out CMD SET may include at least one command and an address for a target plane on which a data out operation is to be performed. According to one or more embodiments, at least one of the command or the address may include cache latch address information.

In one or more embodiments, as illustrated in the first case, the data-out command set Data Out CMD SET may include a data-out command CMD_Dout and an address ADDR_XY. The address ADDR_XY may include cache latch address information and input/output pad address information. For example, the address ADDR_XY may include not only address information on the target plane but also cache latch address information and input/output pad address information.

For example, the address ADDR_XY may be 'CCRRRRXY,' where CCRRRR is column address and row address information on the target plane, X is cache latch address information, and Y is input/output pad address information. At least one cache latch, among a plurality of cache latches, may be selected based on a value of X. At least one input/output pad, among a plurality of input/output pads, may be selected based on a value of Y.

An illustrative example is provided for clarity, where page buffers corresponding to the target plane each include a first cache latch and a second cache latch. For example, when the value of X is 1, the first cache latch of each page buffer may be selected. For example, when the value of X is 2, the second cache latch of each page buffer may be selected. For example, when the value of X is 3, the first cache latch may be selected in a portion of the page buffers (e.g., a first set of page buffers) of the target plane, and the second cache latch may be selected in the remaining page buffers (e.g., a second set of page buffers). However, this is an example, and the cache latch address information and the cache latches selected accordingly may be configured in various ways according to embodiments.

In addition, an illustrative example is provided for clarity, where a first input/output pad and a second input/output pad are provided. For example, when the value of Y is 1, the first input/output pad may be selected. For example, when the value of Y is 2, the second input/output pad may be selected. For example, when the value of Y is 3, both the first input/output pad and the second input/output pad may be selected. However, this is an example, and the input/output pad address information and the input/output pads selected accordingly may be configured in various ways according to embodiments.

In one or more embodiments, as illustrated in the second case, the data-out command set Data Out CMD SET may include a data-out command CMD_Dout_XY and an address ADDR. The data-out command CMD_Dout_XY may include cache latch address information and input/output pad address information. For example, the data-out command CMD_Dout_XY may be a command encoded to include cache latch address information and input/output pad address information.

For example, the data-out command CMD_Dout_XY may be '06XYh,' where X is cache latch address information and Y is input/output pad address information. At least one cache latch among a plurality of cache latches may be selected based on the value of X, and at least one input/output pad among a plurality of input/output pads may be selected based on the value of Y.

In one or more embodiments, as illustrated in the third and fourth cases, the data-out command set Data Out CMD SET may include a plurality of data-out commands CMD_Dout and CMD_Dout' and an address ADDR_XY. The order of the plurality of data-out commands CMD_Dout and CMD_Dout' and the address ADDR_XY may be configured in various ways.

For example, as in the third case, the data-out command set Data Out CMD SET may be configured in the order of command CMD_Dout, address ADDR_XY, and command CMD_Dout'. For example, as in the fourth case, the data-out command set Data Out CMD SET may be configured in the order of command CMD_Dout, command CMD_Dout', and address ADDR_XY. However, this is an example, and the number and order of commands and addresses may be configured in various ways according to embodiments.

FIG. 3B is an example, and it will be understood that embodiments are not limited thereto. According to one or more embodiments, cache latch address information and input/output pad address information may be distributed and included in commands and addresses.

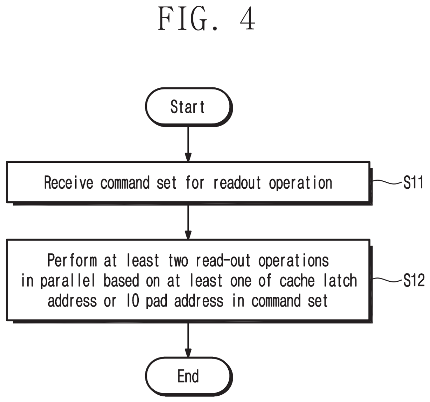

FIG. 4 is a flowchart illustrating a readout operation according to one or more embodiments.

In operation S11, a command set for a readout operation may be received.

For example, the nonvolatile memory device 11A or 11B (see FIG. 1A or 1B) may receive a read command set Read CMD SET (see FIG. 3A) and/or a data-out command set Data Out CMD SET (see FIG. 3B) generated by the memory controller 12A or 12B. At least one of the read command set Read CMD SET or the data-out command set Data Out CMD SET may include at least one of cache latch address information or input/output pad address information.

In operation S12, readout operations may be performed in parallel based on at least one of cache latch address information or input/output pad address information included in the command set.

For example, the nonvolatile memory device 11A or 11B may perform a read operation and/or a data-out operation in parallel on a plurality of planes or on a single plane, based on cache latch address information and/or input/output pad address information included in at least one of the read command set Read CMD SET or the data-out command set Data Out CMD SET. For example, a read operation may be performed at two addresses in parallel based on two read command sets Read CMD SET having different input/output pad address information, or a read operation may be performed at cache latches in parallel based on two read command sets Read CMD SET having different cache latch address information.

As described above, readout operations may be performed in parallel based on at least one of input/output pad address or cache latch address, improving data input/output performance.

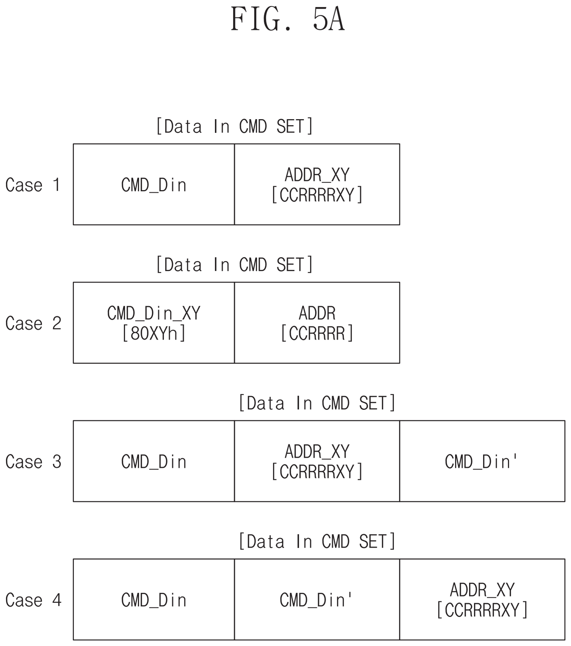

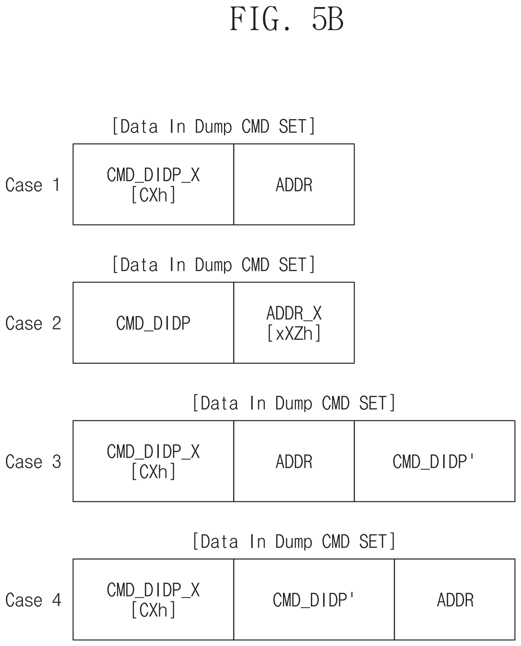

FIGS. 5A and 5B are diagrams illustrating examples of command sets for a write operation. FIG. 5A is a diagram illustrating examples of a data-in command set, and FIG. 5B is a diagram illustrating examples of a data-in dump command set.

Referring to FIG. 5A, a data-in command set Data In CMD SET may include at least one command and an address for a target plane on which a data-in operation is to be performed. According to one or more embodiments, at least one of the command or the address may include cache latch address information and/or input/output pad address information.

In one or more embodiments, as illustrated in the first case, the data-in command set Data In CMD SET may include a data-in command CMD_Din and an address ADDR_XY. The address ADDR_XY may include cache latch address information and input/output pad address information. For example, the address ADDR_XY may include not only address information on the target plane but also cache latch address information and input/output pad address information.

For example, the address ADDR_XY may be 'CCRRRRXY,' where 'CCRRRR' is column address and row address information on the target plane, 'X' is cache latch address information, and 'Y' is input/output pad address information. At least one cache latch, among a plurality of cache latches, may be selected based on a value of 'X.' At least one input/output pad, among a plurality of input/output pads, may be selected based on a value of 'Y.'

In one or more embodiments, as illustrated in the second case, the data-in command set Data In CMD SET may include a data-in command CMD_Din_XY and an address ADDR. The data-in command CMD_Din_XY may include cache latch address information and input/output pad address information. For example, the data-in command CMD_Din_XY may be a command encoded to include cache latch address information and input/output pad address information.

For example, the data-in command CMD_Din_XY may be '80XYh,' where 'X' is cache latch address information and 'Y' is input/output pad address information. At least one cache latch, among a plurality of cache latches, may be selected based on the value of 'X.' At least one input/output pad, among a plurality of input/output pads, may be selected based on the value of 'Y.'

In one or more embodiments, as illustrated in the third and fourth cases, the data-in command set Data In CMD SET may include a plurality of data-in commands CMD_Din, CMD_Din' and an address ADDR_XY. The order of the plurality of data-in commands CMD_Din, CMD_Din', and the address ADDR_XY may be configured in various ways.

For example, as in the third case, the data-in command set Data In CMD SET may be configured in the order of command CMD_Din, address ADDR_XY, and command CMD_Din'. For example, as in the fourth case, the data-in command set Data In CMD SET may be configured in the order of command CMD_Din, command CMD_Din', address ADDR_XY. However, this is an example, the number and order of commands and addresses may be configured in various ways according to one or more embodiments.

Referring to FIG. 5B, a data-in dump command set Data In Dump CMD SET may include at least one command and an address for a target data latch on which a data-in dump operation is to be performed. According to one or more embodiments, at least one of the command or the address may include cache latch address information.

In one or more embodiments, as illustrated in the first case, the data-in dump command set Data In Dump CMD SET may include a data-in dump command CMD_DIDP_X and an address ADDR. The data-in dump command CMD_DIDP_X may include cache latch address information. For example, the data-in dump command CMD_DIDP_X may be a command encoded to include cache latch address information.

For example, the data-in dump command CMD_DIDP_X may be 'CXh,' where 'X' is cache latch address information. At least one cache latch, among a plurality of cache latches, may be selected based on the value of 'X.'

In one or more embodiments, as illustrated in the second case, the data-in dump command set Data In Dump CMD SET may include a data-in dump command CMD_DIDP and an address ADDR_X. The address ADDR_X may include cache latch address information. For example, the address ADDR_X may include not only address information on the target data latch but also cache latch address information.

For example, the address ADDR_X may be 'xXZh,' where 'Z' is address information on the target data latch and 'X' is cache latch address information. At least one cache latch, among a plurality of cache latches, may be selected based on the value of 'X,' and at least one data latch, among a plurality of data latches, may be selected based on the value of 'Z.' Accordingly, a data-in dump operation may be performed to move data from the selected cache latch to the selected data latch.

In one or more embodiments, as illustrated in the third and fourth cases, the data-in dump command set Data In Dump CMD SET may include a plurality of data-in dump commands CMD_DIDP_X, CMD_DIDP', and an address ADDR. The order of the plurality of data-in dump commands CMD_DIDP and CMD_DIDP' and the address ADDR may be configured in various ways.

For example, as in the third case, the data-in dump command set Data In Dump CMD SET may be configured in the order of command CMD_DIDP_X, address ADDR, and command CMD_DIDP'. For example, as in the fourth case, the data-in dump command set Data In Dump CMD SET may be configured in the order of command CMD_DIDP_X, command CMD_DIDP', and address ADDR. However, this is an example, and the number and order of commands and addresses may be configured in various ways according to one or more embodiments.

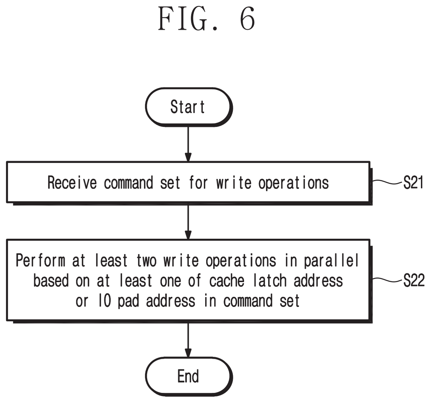

FIG. 6 is a flowchart illustrating a write operation according to one or more embodiments.

In operation S21, a command set for a write operation may be received.

For example, the nonvolatile memory device 11A or 11B (see FIG. 1A or 1B) may receive a data-in command set Data In CMD SET (see FIG. 5A) and/or a data-in dump command set Data In Dump CMD SET (see FIG. 5B) generated by the memory controller 12A or 12B. At least one of the data-in command set Data In CMD SET or the data-in dump command set Data In Dump CMD SET may include at least one of cache latch address information or input/output pad address information.

In operation S22, write operations may be performed in parallel based on at least one of cache latch address information or input/output pad address information included in the command set.

For example, the nonvolatile memory device 11A or 11B may perform a data-in operation and/or a data-in dump operation in parallel on a plurality of planes or a single plane, based on cache latch address information and/or input/output pad address information included in at least one of the data-in command set Data In CMD SET or the data-in dump command set Data In Dump CMD SET. For example, a write operation may be performed at two addresses in parallel based on two command sets Data In CMD SET or Data In Dump CMD SET having different input/output pad address information, or a write operation may be performed at cache latches in parallel based on two command sets Data In CMD Set or Data In Dump CMD SET having different cache latch address information.

As described above, write operations may be performed in parallel based on at least one of input/output pad address or cache latch address, improving data input/output performance.

Hereinafter, examples of the configuration and operation of a storage system according to one or more embodiments will be described in greater detail.

[Example of Configuration of Memory Controller]

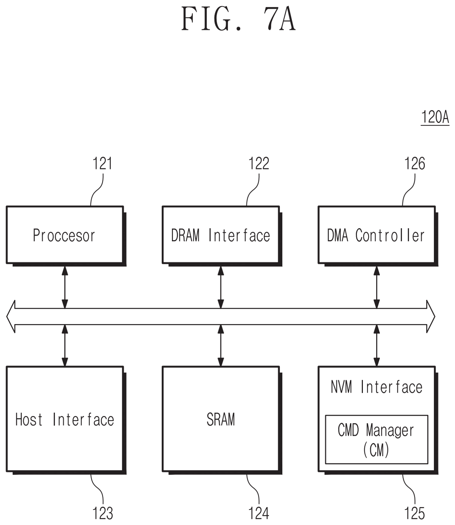

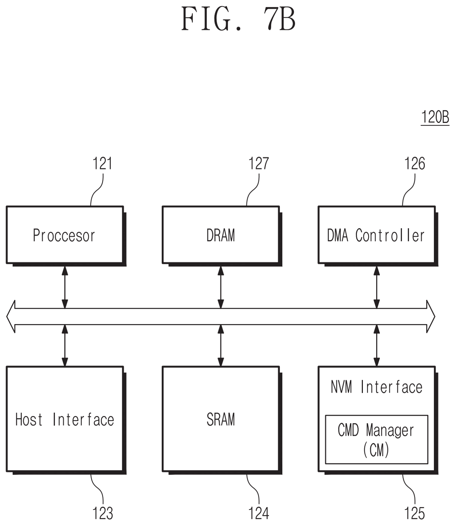

FIGS. 7A and 7B are block diagrams illustrating memory controllers 120A and 120B according to one or more embodiments in greater detail, respectively. Each of the memory controller 120A of FIG. 7A and the memory controller 120B of FIG. 7B may correspond to the memory controller 12A of FIG. 1A or to the memory controller 12B of FIG. 1B.

Referring to FIG. 7A, the memory controller 120A may include a processor 121, a DRAM interface 122, a host interface 123, an SRAM 124, a nonvolatile memory interface 125, and a DMA controller 126.

The processor 121 may control the overall operation of the memory controller 120A. For example, the processor 121 may execute various applications running on the memory controller 120A.

The DRAM interface 122 may provide interfacing with an external DRAM device. For example, the memory controller 120A may temporarily store data in the DRAM device or read data stored in the DRAM device through the DRAM interface 122.

The host interface 123 may provide interfacing with an external host. For example, the memory controller 120A may communicate with the host through the host interface 123. For example, the host interface 123 may include at least one of various host interfaces such as a Peripheral Component Interconnect express (PCI-express) interface, a nonvolatile memory express (NVMe) interface, a Serial ATA (SATA) interface, a Serial Attached SCSI (SAS) interface, a Universal Flash Storage (UFS) interface, or the like.

The SRAM 124 may be used as a buffer memory, a working memory, or a cache memory for the memory controller 120A. For example, the SRAM 124 may store various types of data such as programs, applications, firmware, or the like, executed by the processor 121.

The nonvolatile memory interface 125 may provide interfacing with the nonvolatile memory device 11A or 11B. For example, the memory controller 120A may communicate with the nonvolatile memory device 11A or 11B through the nonvolatile memory interface 125.

The nonvolatile memory interface 125 may include a command manager CM. The command manager CM may generate various command sets to control the nonvolatile memory device 11A or 11B.

In one or more embodiments, the command manager CM may generate various commands such as the read command set, the data-out command set, the data-in command set, and the data-in dump command set described in FIGS. 3A, 3B, 5A, and 5B. The command set generated by the command manager CM may include at least one of cache latch address information or input/output pad address information. Accordingly, readout operations and/or write operations may be performed in parallel, improving data input/output performance.

According to one or more embodiments, the memory controller 120A may further include a DMA controller 126. The DMA controller 126 may control data transfer between the DRAM device and the nonvolatile memory device 11A or 11B.

For example, a DMA operation may be performed in units of planes. Data stored in the nonvolatile memory device 11A or 11B may be transferred to the DRAM device in units of planes, or data stored in the DRAM device may be transferred to the nonvolatile memory device 11A or 11B in units of planes. However, this is an example, and embodiments are not limited thereto. According to one or more embodiments, the DMA operation may be performed in units, smaller than a plane, such as blocks.

In FIG. 7A, the DRAM device has been described as being disposed outside the memory controller 120A. However, this is an example, and embodiments are not limited thereto. For example, referring to FIG. 7B, the memory controller 120B may be implemented to include a DRAM device 127. The memory controller 120B may be, for example, a semiconductor chip or package including stack of semiconductor chips, or may be a module, for example, formed on a printed circuit board and including a plurality of semiconductor chips and/or packages.

In addition, in FIG. 7A, the DMA controller 126 has been described as being disposed inside the memory controller 120A. However, this is an example, and embodiments are not limited thereto. According to one or more embodiments, the DMA controller 126 may be implemented to be disposed outside the memory controller 120A.

### [Example of Configuration of Nonvolatile Memory Device]

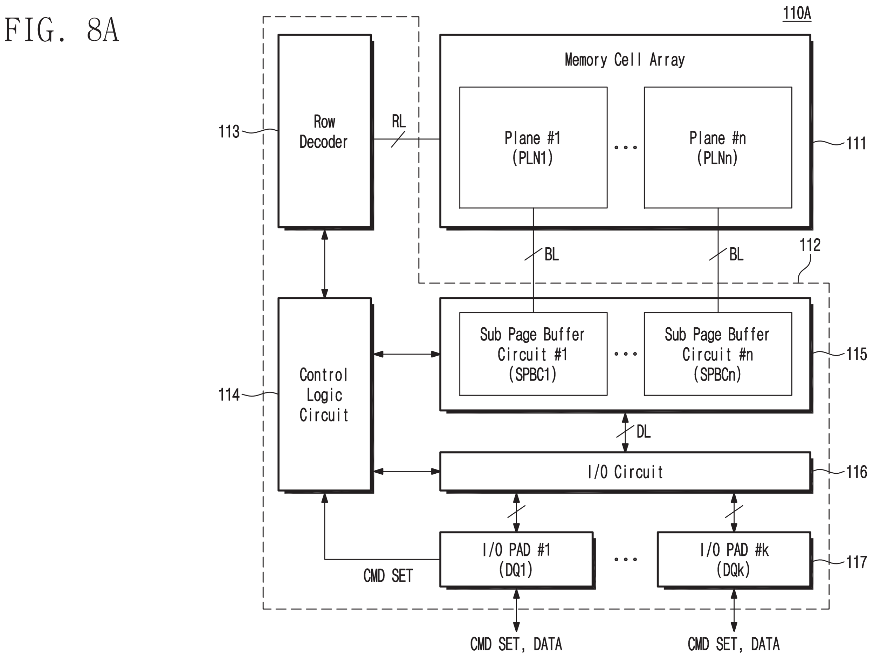

FIG. 8A is a block diagram illustrating a nonvolatile memory device 110A according to one or more embodiments in greater detail. The nonvolatile memory device of FIG. 8A may correspond to the nonvolatile memory device 11A of FIG. 1A.

Referring to FIG. 8A, a nonvolatile memory device 110A may include a memory cell array 111 and a peripheral circuit 112. The peripheral circuit 112 may include an address decoder 113, a control logic circuit 114, a page buffer circuit 115, an input/output circuit 116, and an input/output pad 117.

The memory cell array 111 may include a plurality of planes PLN1 to PLNn, and each of the plurality of planes PLN1 to PLNn may include memory blocks. Each of the memory blocks may have a two-dimensional (2D) structure or a three-dimensional (3D) structure. In a memory block having a 2D structure (or a horizontal structure), memory cells may be formed in a direction parallel to a substrate. In a memory block having a 3D structure (or a vertical structure), memory cells may be formed in a direction perpendicular to the substrate as well as parallel to the substrate.

The plurality of memory blocks may include at least one of a single-level cell (SLC) block including SLCs, a multi-level cell (MLC) block including MLCs, a triple-level cell (TLC) block including TLCs, and a quad-level cell (QLC) block including QLCs. Among the plurality of memory blocks included in the memory cell array 111, some memory blocks may be single-level cell blocks, while other memory blocks may be multi-level cell blocks or triple-level cell blocks.

The address decoder 113 (e.g., a row decoder) may be connected to the memory cell array 111 through row lines RL. The row lines RL may include string select lines, ground select lines, wordlines, dummy wordlines, or GIDL lines.

The page buffer circuit 115 may be connected to the memory cell array 111 through bitlines BL. The page buffer circuit 115 may temporarily store data to be programmed into a selected page or may temporarily store data read from a selected page. The page buffer circuit 115 may include a plurality of sub-page buffer circuits SPBC1 to SPBCn.

The plurality of sub-page buffer circuits SPBC1 to SPBCn may be connected to the plurality of planes PLN1 to PLNn through bitlines BL, respectively. For example, the first sub-page buffer circuit SPBC1 may be connected to the first plane PLN1 through bitlines BL, and the n-th sub-page buffer circuit SPBCn may be connected to the n-th plane PLNn through bitlines BL.

Each sub-page buffer circuit may include a plurality of page buffers, respectively connected to a plurality of bitlines BL. For example, a single page buffer may be disposed to correspond to a single bitline, and each page buffer may include at least one cache latch.

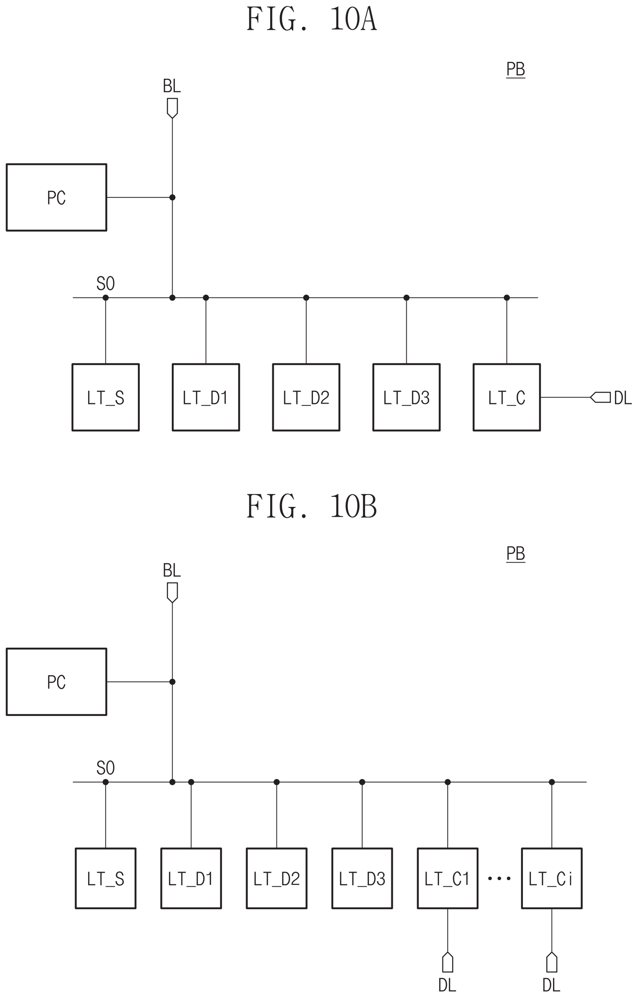

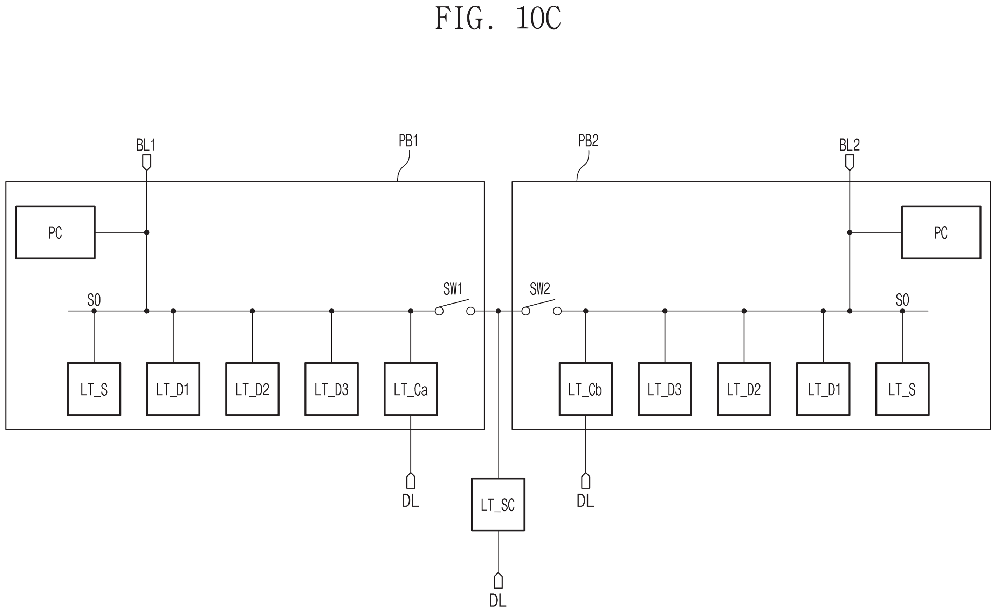

In one or more embodiments, as described below in FIG. 10A, a page buffer may include a single cache latch. Alternatively, in one or more embodiments, as described below in FIG. 10B, a single page buffer may include a plurality of cache latches. Alternatively, in one or more embodiments, as described below in FIG. 10C, different page buffers may share at least one cache latch. The shared cache latch may be disposed in the page buffer circuit 115, in the input/output circuit 116, or in a circuit for one of the input/output pads DQ1 to DQk.

The input/output circuit 116 may be connected to the page buffer circuit 115 through data lines DL. The input/output circuit 116 may receive data DATA through the input/output pads DQ1 to DQk and transfer the received data DATA to the page buffer circuit 115. In addition, the input/output circuit 116 may receive data DATA from the page buffer circuit 115 and transmit the received data DATA to the memory controller 12A through the plurality of input/output pads DQ1 to DQk.

The plurality of input/output pads DQ1 to DQk may receive a command set CMD SET and data DATA from the memory controller 12A. The plurality of input/output pads DQ1 to DQk may transfer the received command set CMD SET to the control logic circuit 114 and transfer the received data DATA to the input/output circuit 116. In addition, the plurality of input/output pads DQ1 to DQk may receive data DATA from the input/output circuit 116 and transmit the received data DATA to the memory controller 12A.

The control logic circuit 114 may receive a command set CMD SET from the plurality of input/output pads DQ1 to DQk. The control logic circuit 114 may control the overall operation of the nonvolatile memory device 110A based on the received command set CMD SET.

In one or more embodiments, the command set CMD SET may include cache latch address information and/or input/output pad address information.

In one or more embodiments, a readout operation and/or a write operation on at least two target planes, among the plurality of planes PLN1 to PLNn, may be performed in parallel based on the cache latch address information and/or input/output pad address information included in the command set CMD SET. This will be described in greater detail below.

In one or more embodiments, a readout operation and/or a write operation on a single target plane may be performed in parallel based on the cache latch address information and/or input/output pad address information included in the command set CMD SET. This will be described in greater detail below.

In one or more embodiments, a core operation in a page buffer and a data transmission/reception operation at the input/output pads may be performed in parallel based on the cache latch address information and/or input/output pad address information included in the command set CMD SET. This will be described in more detail below.

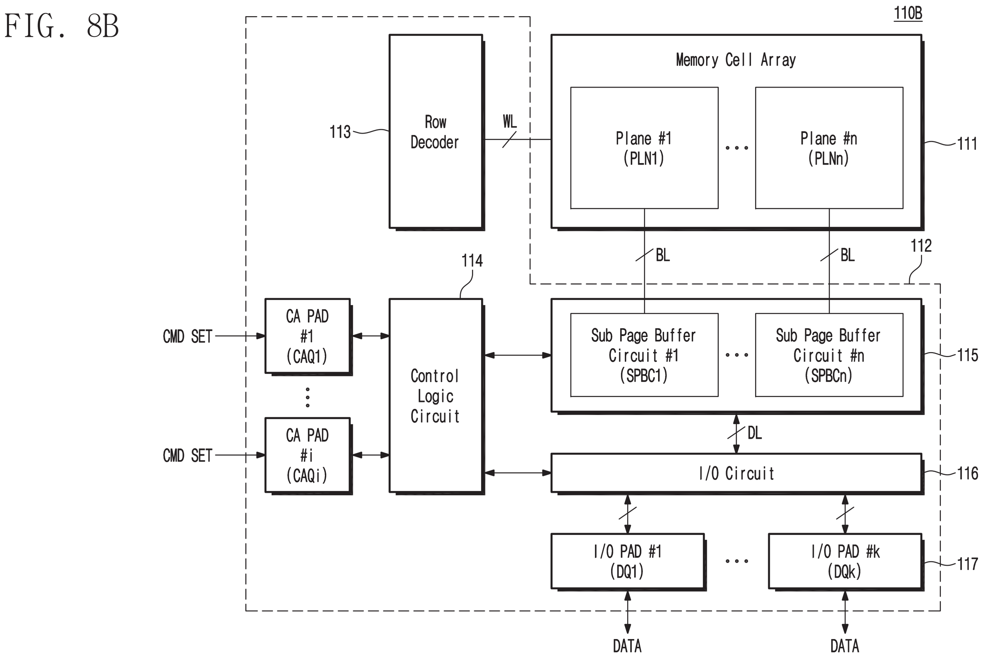

FIG. 8B is a block diagram illustrating a nonvolatile memory device 110B according to one or more embodiments in greater detail. The nonvolatile memory device of FIG. 8B may correspond to the nonvolatile memory device 11B of FIG. 1B. The nonvolatile memory device 110B of FIG. 8B is similar to the nonvolatile memory device 110A of FIG. 8A. Therefore, the same or substantially the same components are denoted by the same or substantially the same reference numerals, and redundant descriptions will be omitted.

Referring to FIG. 8B, the nonvolatile memory device 110B may include at least one command address pad (hereinafter referred to as "CA pad" CAQ1 to CAQi). The nonvolatile memory device 110B may receive or transmit a command set CMD SET through at least one CA pad CAQ1 to CAQi.

For example, the nonvolatile memory device 110B may receive a command set CMD SET for a data output operation from the memory controller 12B (see FIG. 1B) through at least one CA pad CAQ1 to CAQi. The at least one CA pad CAQ1 to CAQi may each transmit the received command set CMD SET to the control logic circuit 114. The command set CMD SET may include cache latch address information and/or input/output pad address information.

The nonvolatile memory device 110B may include a plurality of input/output pads DQ1 to DQk. The nonvolatile memory device 110B may receive or transmit data DATA through the plurality of input/output pads DQ1 to DQk.

As described above, the nonvolatile memory device 110B according to one or more embodiments may include at least one CA pad CAQ1 to CAQi and a plurality of input/output pads DQ1 to DQk. The command set CMD SET may be received through the at least one CA pad CAQ1 to CAQi, and data DATA may be received or transmitted through a selected input/output pad among the plurality of input/output pads DQ1 to DQk.

Separating the transmission paths of the command set CMD SET and data DATA enables the data input/output operation according to one or more embodiments to reduce command-address overhead. As a result, data input/output performance may be further improved.

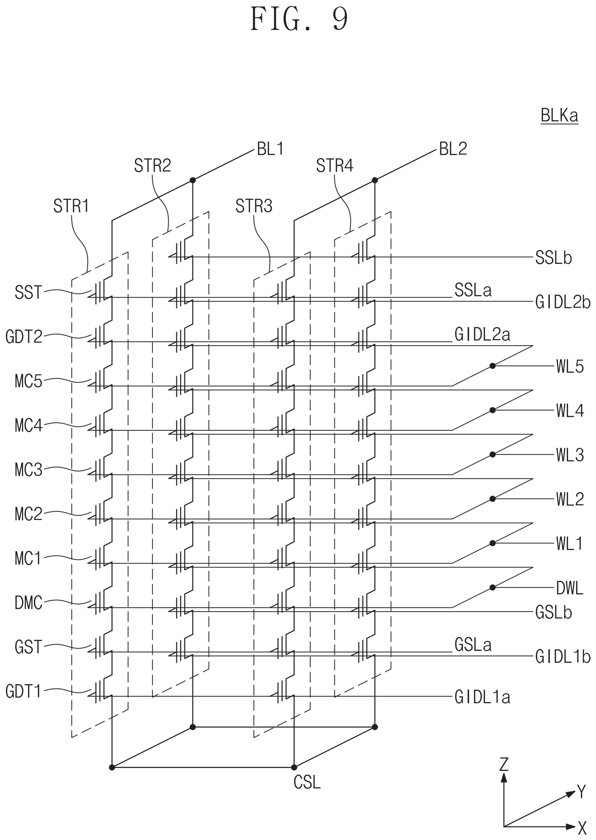

FIG. 9 is a circuit diagram illustrating a single memory block, among a plurality of memory blocks according to one or more embodiments. The memory block of FIG. 9 may be one of the memory blocks included in the planes of FIGS. 8A and 8B. An illustrative example is provided for clarity, where a single memory block includes four strings STR1 to STR4.

Referring to FIG. 9, a memory block BLKa may include a plurality of strings STR1 to STR4, vertically stacked on a substrate. The plurality of strings STR1 to STR4 may be arranged in a first direction (X-axis direction) and a second direction (Y-axis direction).

Among the plurality of strings STR1 to STR4, strings disposed in the same column may be connected to the same bitline. For example, the first and second strings STR1 and STR2 may be connected to a first bitline BL1, and the third and fourth strings STR3 and STR4 may be connected to a second bitline BL2.

Each of the plurality of strings STR1 to STR4 may include a plurality of cell transistors. Each of the plurality of cell transistors may be a charge trap flash (CTF) memory cell, but embodiments are not limited thereto. The plurality of cell transistors may be stacked in a third direction (Z-axis direction).

The plurality of strings STR1 to STR4 may be commonly connected to a common source line CSL. For example, as illustrated in FIG. 9, the common source line CSL may be commonly connected to lower ends of the plurality of strings STR1 to STR4. However, this is an example, and it is sufficient for the common source line CSL to be electrically connected to the lower ends of the strings STR1 to STR4, and it need not be physically disposed at the lower ends of the strings STR1 to STR4. Hereinafter, for clarity, the structure and configuration of a string will be described with reference to the first string STR1. The other strings STR2, STR3, and STR4 may have a structure similar to that of the first string STR1, and detailed descriptions thereof will be omitted.

The plurality of cell transistors may be connected in series between the first bitline BL1 and the common source line CSL. For example, the plurality of cell transistors may include GIDL (gate-induced drain leakage) transistors GDT1 and GDT2, a string select transistor SST, memory cells MC1 to MC5, a dummy memory cell DMC, and ground select transistors GST.

The first GIDL transistors GDT1 may be disposed at a lowermost end of the string STR1. For example, the first GIDL transistor GDT1 may be connected to the common source line CSL at the lower end of the string STR1. However, this is an example, and embodiments are not limited thereto. A gate of the first GIDL transistor GDT1 may be connected to a first GIDL line GIDL1a.

The second GIDL transistor GDT2 may be disposed at an upper end of the string STR1 between the string select transistor SST and the memory cell MC5. For example, the second GIDL transistor GDT2 may be connected to the first bitline BL1 through the string select transistor SST. The gate of the second GIDL transistor GDT2 may be connected to thesecond GIDL line GIDL2a.

In FIG. 9, the GIDL transistors GDT1 and GDT2 are illustrated as being provided at the upper end and the lower end of the string STR1. However, this is an example, and a GIDL transistor may be provided only at the upper end of the string STR1 or only at the lower end of the string STR1.

A single string select transistor SST may be disposed at an uppermost end of the string STR. The string select transistor SST may be connected to the first bitline BL1 at the uppermost end of the string STR1. A gate of the string select transistor SST may be connected to a string select line SSLa. However, this is an example, and according to one or more embodiments, a plurality of string select transistors connected in series may be provided between the first bitline BL1 and the second GIDL transistor GDT2.

A single ground select transistor GST may be provided between the dummy memory cell DMC and the first GIDL transistor GDT1. A gate of the ground select transistor GST may be connected to a ground select line GSLa. However, this is an example, and according to one or more embodiments, a plurality of ground select transistors connected in series may be provided between the dummy memory cell DMC and the first GIDL transistor GDT1.

The first to fifth memory cells MC1 to MC5 may be connected in series between the string select transistor SST and the dummy memory cell DMC. Gates of the first to fifth memory cells MC1 to MC5 may be connected to first to fifth wordlines WL1 to WL5, respectively.

A single dummy memory cell DMC may be provided between the first memory cell MC1 and the first GIDL transistor GDT1. A gate of the dummy memory cell DMC may be connected to a dummy wordline DWL. This is an example, and according to one or more embodiments, a plurality of dummy memory cells connected in series may be provided between the first memory cell MC1 and the first GIDL transistor GDT1. Alternatively, an additional dummy memory cell may be provided between the string select transistor SST and the fifth memory cell MC5. Alternatively, an additional dummy memory cell may be provided between the memory cells MC1 to MC5. Alternatively, a dummy memory cell DMC may not be provided.

FIGS. 10A to 10C are block diagrams illustrating a page buffer according to one or more embodiments. For example, the page buffer of FIG. 10A may correspond to one of the page buffers included in the sub-page buffer circuits of FIGS. 8A and 8B.

Referring to FIG. 10A, the page buffer PB may be connected to a bitline BL. The page buffer PB may include a sensing node SO connected to the bitline BL. In addition, the page buffer PB may include a precharge circuit PC and a plurality of latches LT_S, LT_D1 to LT_D3, and LT_C, each connected to the sensing node SO.

The precharge circuit PC may precharge the bitline BL to either a program allow voltage or a program inhibit voltage under the control of the control logic circuit 114 (see FIGS. 8A and 8B).

Among the plurality of latches LT_S, LT_D1 to LT_D3, and LT_C, the sensing latch LT_S may store data sensed through the bitline BL. Alternatively, the sensing latch LT_S may store precharge data used to determine the precharge voltage.

Among the plurality of latches LT_S, LT_D1 to LT_D3, and LT_C, the data latches LT_D1 to LT_D3 may temporarily store data to be programmed into a memory cell. For example, when a memory cell stores 3 bits of data, the data latches LT_D1 to LT_D3 may store data corresponding to a most significant page, data corresponding to a middle page, and data corresponding to a least significant page, respectively.

Among the plurality of latches LT_S, LT_D1 to LT_D3, LT_C, the cache latch LT_C may be connected to one of the plurality of input/output pads DQ1 to DQk through a data line DL. The cache latch LT_C may store data received from a corresponding input/output pad among the plurality of input/output pads DQ1 to DQk. Alternatively, the cache latch LT_C may temporarily store data to be transmitted to a corresponding input/output pad among the plurality of input/output pads DQ1 to DQk.

In FIG. 10A, the page buffer PB has been described as including five latches. However, this is an example, and the number of latches included in the page buffer PB is not limited thereto.

Referring to FIG. 10B, the page buffer PB may include a plurality of cache latches LT_C1 to LT_Ci. Each of the plurality of cache latches LT_C1 to LT_Ci may be connected to a corresponding data line. The data lines may be connected to a plurality of input/output pads DQ1 to DQk. For example, the data lines may be connected to different input/output pads. However, this is an example, and according to one or more embodiments, the data lines may be connected to the same input/output pad.

During a readout operation, data transmitted through the bitline BL may be temporarily stored in a selected cache latch among the plurality of cache latches LT_C1 to LT_Ci. Then, the data stored in the selected cache latch may be transmitted to a selected input/output pad, among the plurality of input/output pads DQ1 to DQk, through the data line.

Alternatively, during a write operation, a cache latch among the plurality of cache latches LT_C1 to LT_Ci may be selected. Data may be transmitted to the selected cache latch through a data line, and the transmitted data may be temporarily stored in the selected cache latch. Then, the data stored in the selected cache latch may be programmed into a corresponding memory cell through a bitline BL.

Referring to FIG. 10C, a shared cache latch LT_SC may be provided. For example, page buffers may share at least one cache latch with each other.

For example, a first page buffer PB1 and a second page buffer PB2 may each include a single cache latch and share a single shared cache latch LT_SC. The shared cache latch LT_SC may be electrically connected to or disconnected from the first page buffer PB1 through a first switch SW1. The shared cache latch LT_SC may be electrically connected to or disconnected from the second page buffer PB2 through a second switch SW2.

In one or more embodiments, a readout operation on a plane connected to the first page buffer PB1 may be performed. The first switch SW1 is turned on, and the first page buffer PB1 corresponds to two cache latches LT_Ca and LT_SC. Data transmitted to the first page buffer PB1 through the first bitline BL1 may be temporarily stored in a selected cache latch among the cache latch LT_Ca or the shared cache latch LT_SC. Then, the data stored in the selected cache latch may be transmitted to a selected input/output pad, among the plurality of input/output pads DQ1 to DQk, through a corresponding data line.

In one or more embodiments, a readout operation on a plane connected to the second page buffer PB2 may be performed. The second switch SW2 is turned on, and the second page buffer PB2 corresponds to two cache latches LT_Cb and LT_SC. Data transmitted to the second page buffer PB2 through the second bitline BL2 may be temporarily stored in a selected cache latch, among the cache latch LT_Cb or the shared cache latch LT_SC.

Similarly, during a write operation on a plane connected to the first page buffer PB1, the first switch SW1 may be turned on. Accordingly, the first page buffer PB1 corresponds to two cache latches LT_Ca and LT_SC. In addition, during a write operation on a plane connected to the second page buffer PB2, the second switch SW2 may be turned on. Accordingly, the second page buffer PB2 corresponds to two cache latches LT_Cb and LT_SC.

### [Examples of Connection Relationship between Cache Latches and Input/Output pads in a Plurality of Planes]

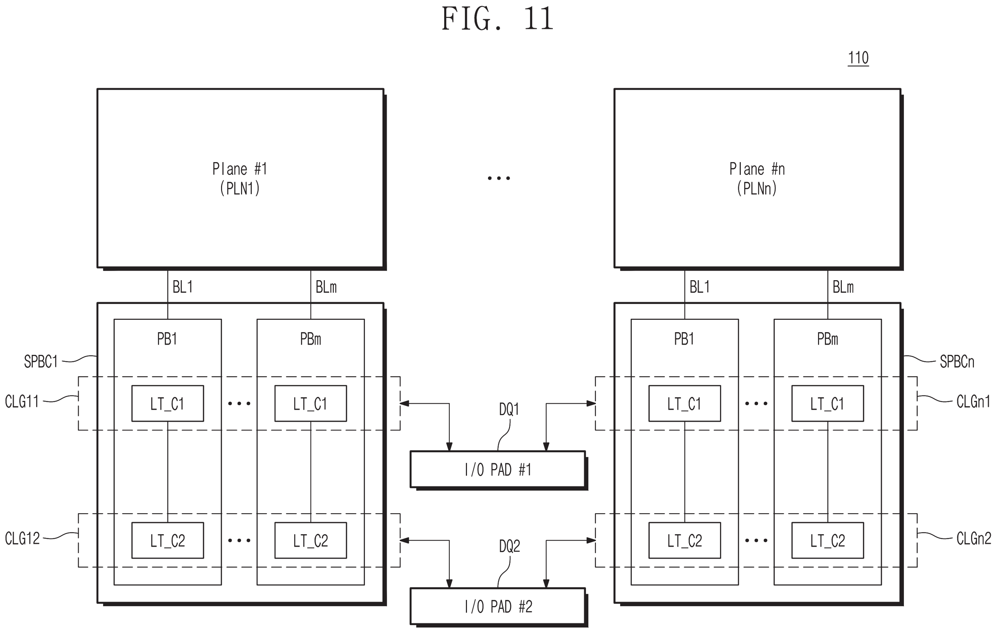

FIG. 11 is a diagram illustrating a correspondence relationship between input/output pads and cache latches in a nonvolatile memory device 110 according to one or more embodiments. FIG. 11 illustrates an example where input/output pads are pre-assigned to specific cache latches. An illustrative example is provided for clarity, where the nonvolatile memory device 110 includes two input/output pads DQ1 and DQ2, and each page buffer includes two cache latches LT_C1 and LT_C2.

Referring to FIG. 11, a plurality of planes PLN1 to PLNn may each be connected to a corresponding sub-page buffer circuit, among a plurality of sub-page buffer circuits SPBC1 to SPBCn, through bitlines BL1 to BLm.

Each sub-page buffer circuit may include a plurality of page buffers, and each of the plurality of page buffers may include two cache latches.

For example, the first sub-page buffer circuit SPBC1 may include a plurality of page buffers PB1 to PBm, and each of the plurality of page buffers PB1 to PBm may include a first cache latch LT_C1 and a second cache latch LT_C2.

The first cache latches LT_C1 of the first sub-page buffer circuit SPBC1 may form a first cache latch group CLG11. The first cache latch group CLG11 may be connected to the first input/output pad DQ1.

The second cache latches LT_C2 of the first sub-page buffer circuit SPBC1 may form a second cache latch group CLG12. The second cache latch group CLG12 may be connected to the second input/output pad DQ2.

As described above, the first cache latches LT_C1 and the second cache latches LT_C2 corresponding to the first plane PLN1 may be connected to different input/output pads.

Similarly, first cache latches LT_C1 of the n-th sub-page buffer circuit SPBCn may form an n-th cache latch group CLGn1. The n-th cache latch group CLGn1 may be connected to the first input/output pad DQ1.

Second cache latches LT_C2 of the n-th sub-page buffer circuit SPBCn may form an n+1th cache latch group CLGn2. The (n+1)-th cache latch group CLGn2 may be connected to the second input/output pad DQ2.

As described above, the first cache latches LT_C1 and the second cache latches LT_C2 corresponding to the n-th plane PLNn may be connected to different input/output pads.

As described in FIG. 11, each of the plurality of planes PLN1 to PLNn may be connected to a plurality of cache latch groups. In addition, cache latch groups corresponding to the same plane may be connected to different input/output pads, and cache latch groups corresponding to different planes may be connected, in some cases, to the same input/output pad. Accordingly, readout operations and/or write operations may be performed in parallel, improving data input/output performance.

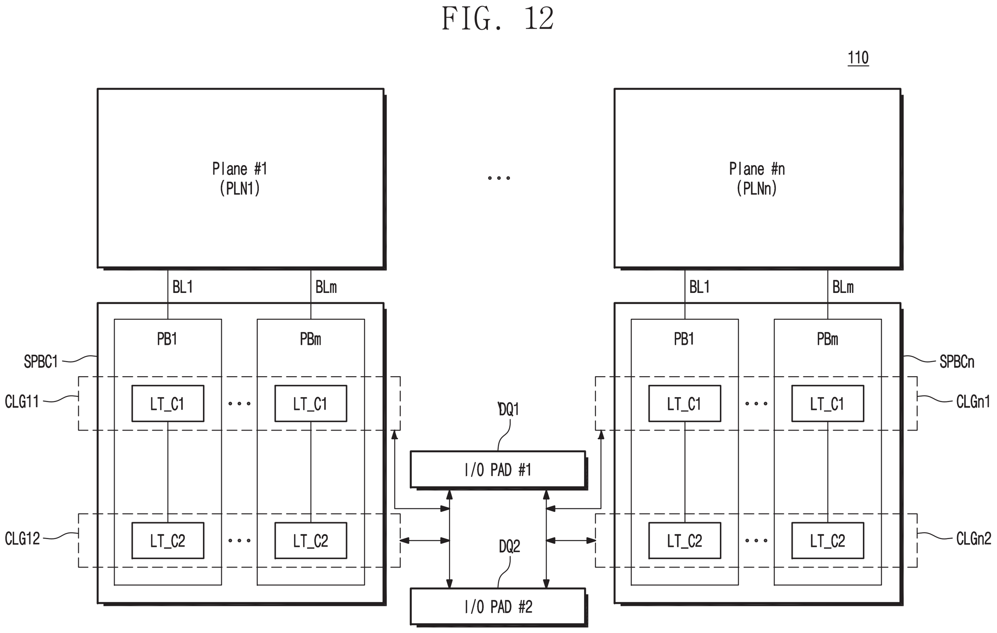

FIG. 12 is a diagram illustrating a correspondence relationship between input/output pads and cache latches in a nonvolatile memory device 110 according to one or more embodiments. FIG. 12 illustrates an example where input/output pads are selectively assigned to cache latches. The nonvolatile memory device of FIG. 12 is similar to the nonvolatile memory device of FIG. 11. Therefore, the same or substantially the same components are denoted by the same or substantially the same reference numerals, and redundant descriptions will be omitted below.

Referring to FIG. 12, a plurality of planes PLN1 to PLNn may each be connected to a corresponding sub-page buffer circuit, among a plurality of sub-page buffer circuits SPBC1 to SPBCn, through bitlines BL1 to BLm.

Each sub-page buffer circuit may include a plurality of page buffers, and each of the plurality of page buffers may include two cache latches.

First cache latches LT_C1 of the first sub-page buffer circuit SPBC1 may form a first cache latch group CLG11. The first cache latch group CLG11 may be selectively connected to either the first input/output pad DQ1 or the second input/output pad DQ2.

Second cache latches LT_C2 of the first sub-page buffer circuit SPBC1 may form a second cache latch group CLG12. The second cache latch group CLG12 may be selectively connected to either the first input/output pad DQ1 or the second input/output pad DQ2.

Similarly, first cache latches LT_C1 of the n-th sub-page buffer circuit SPBCn may form an n-th cache latch group CLGn1. The n-th cache latch group CLGn1 may be selectively connected to either the first input/output pad DQ1 or the second input/output pad DQ2.

Second cache latches LT_C2 of the n-th sub-page buffer circuit SPBCn may form an (n+1)-th cache latch group CLGn2. The (n+1)-th cache latch group CLGn2 may be selectively connected to either the first input/output pad DQ1 or the second input/output pad DQ2.

As described in FIG. 12, each of the plurality of planes PLN1 to PLNn may be connected to a plurality of cache latch groups. In addition, each cache latch group may be selectively connected to an input/output pad. Accordingly, readout operations and/or write operations may be performed in parallel, improving data input/output performance.

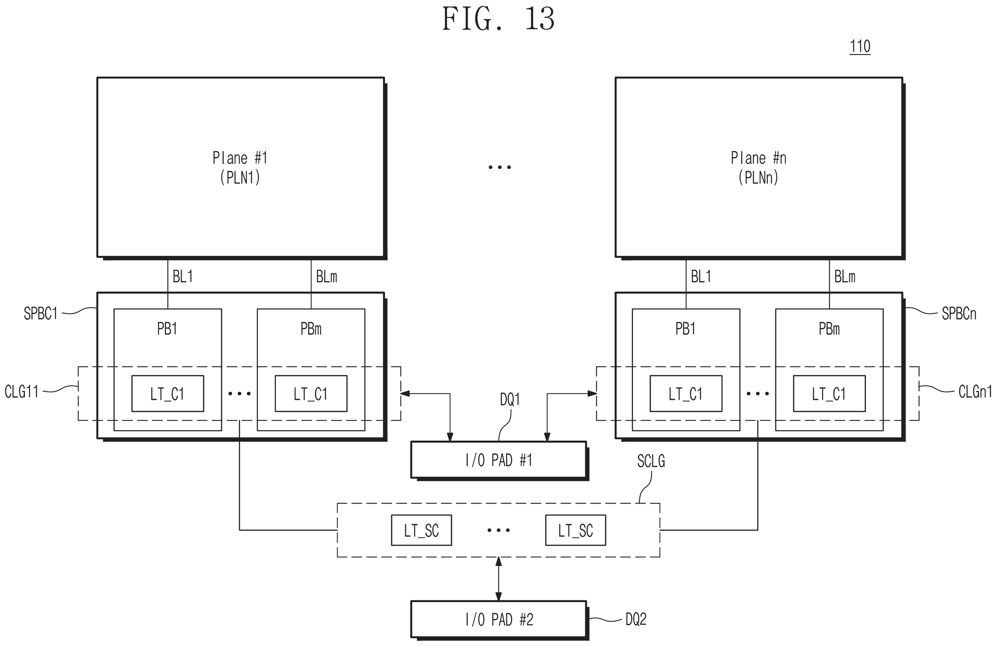

FIG. 13 is a diagram illustrating a correspondence relationship between input/output pads and cache latches in a nonvolatile memory device 110 according to one or more embodiments. FIG. 13 illustrates an example where a shared cache latch is provided. The nonvolatile memory device of FIG. 13 is similar to the nonvolatile memory devices of FIGS. 11 and 12. Therefore, the same or substantially the same components are denoted by the same or substantially the same reference numerals, and redundant descriptions will be omitted below. An illustrative example is provided for clarity, where each page buffer includes one cache latch.

Referring to FIG. 13, a plurality of planes PLN1 to PLNn may each be connected to a corresponding sub-page buffer circuit, among a plurality of sub-page buffer circuits SPBC1 to SPBCn, through bitlines BL1 to BLm.

Each sub-page buffer circuit may include a plurality of page buffers, and each of the plurality of page buffers may include a single cache latch.

First cache latches LT_C1 of the first sub-page buffer circuit SPBC1 may form a first cache latch group CLG11. The first cache latch group CLG11 may be connected to a first input/output pad DQ1.

N-th cache latches LT_C1 of the n-th sub-page buffer circuit SPBCn may form an n-th cache latch group CLGn1. The n-th cache latch group CLGn1 may be connected to the first input/output pad DQ1.

Shared cache latches LT_SC may form a shared cache latch group SCLG.

The shared cache latch group SCLG may be shared by the first sub-page buffer circuit SPBC1 to the n-th sub-page buffer circuit SPBCn and may be selectively connected to one of the first sub-page buffer circuit SPBC1 to the n-th sub-page buffer circuit SPBCn.

The shared cache latch group SCLG may be connected to a second input/output pad DQ2. Accordingly, when the shared cache latch group SCLG is connected to the first sub-page buffer circuit SPBC1, the first cache latch group CLG11 and the shared cache latch group SCLG may be connected to different input/output pads. In addition, when the shared cache latch group SCLG is connected to the n-th sub-page buffer circuit SPBCn, the n-th cache latch group CLGn1 and the shared cache latch group SCLG may be connected to different input/output pads.

As described in FIG. 13, the shared cache latch group may be selectively connected to one of the plurality of planes PLN1 to PLNn. The cache latch group and the shared cache latch group may be connected to different input/output pads. Accordingly, readout operations and/or write operations may be performed in parallel, improving data input/output performance.

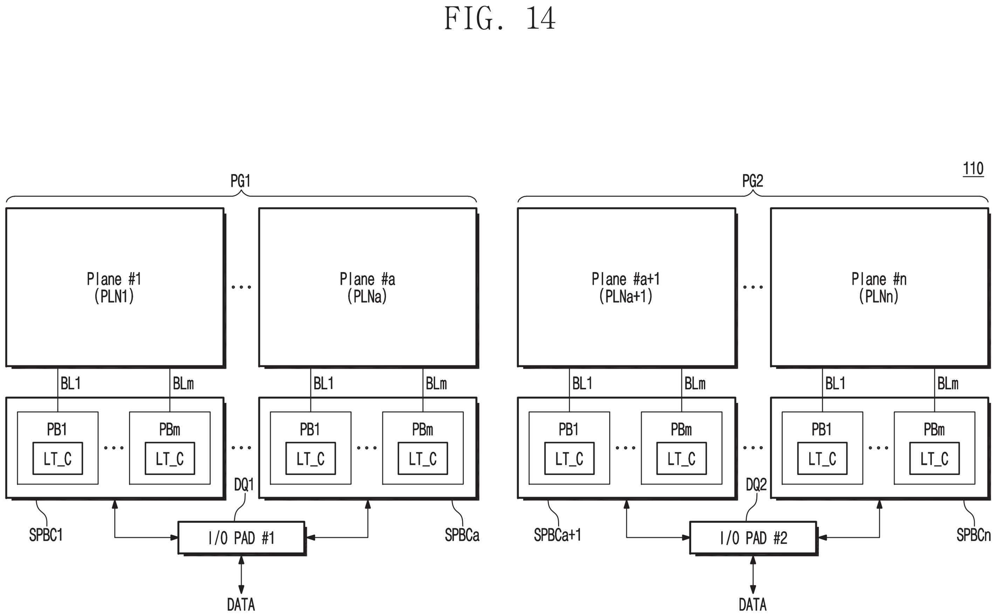

FIG. 14 is a diagram illustrating a correspondence relationship between input/output pads and cache latches in a nonvolatile memory device 110 according to one or more embodiments. FIG. 14 illustrates an example where different input/output pads are pre-assigned to each plane group. The nonvolatile memory device of FIG. 14 is similar to the nonvolatile memory devices of FIGS. 11 to 13. Therefore, the same or substantially the same components are denoted by the same or substantially the same reference numerals, and redundant descriptions will be omitted below. An illustrative example is provided for clarity, where each page buffer includes a single cache latch.

Referring to FIG. 14, a plurality of planes PLN1 to PLNn may each be connected to a corresponding sub-page buffer circuit, among a plurality of sub-page buffer circuits SPBC1 to SPBCn, through bitlines BL1 to BLm. Each sub-page buffer circuit may include a plurality of page buffers, and each of the plurality of page buffers may include a single cache latch LT_C.

The plurality of planes PLN1 to PLNn may be grouped into plane groups. For example, some planes PLN1 to PLNa, among the plurality of planes PLN1 to PLNn, may be grouped into a first plane group PG1, and the remaining planes PLNa+1 to PLNn may be grouped into a second plane group PG2.

A first input/output pad DQ1 may be assigned to the first plane group PG1, and a second input/output pad DQ2 may be assigned to the second plane group PG2. Accordingly, readout operations and/or write operations on planes belonging to the first plane group PG1 and readout operations and/or write operations on planes belonging to the second plane group PG2 may be performed in parallel, improving data input/output performance.

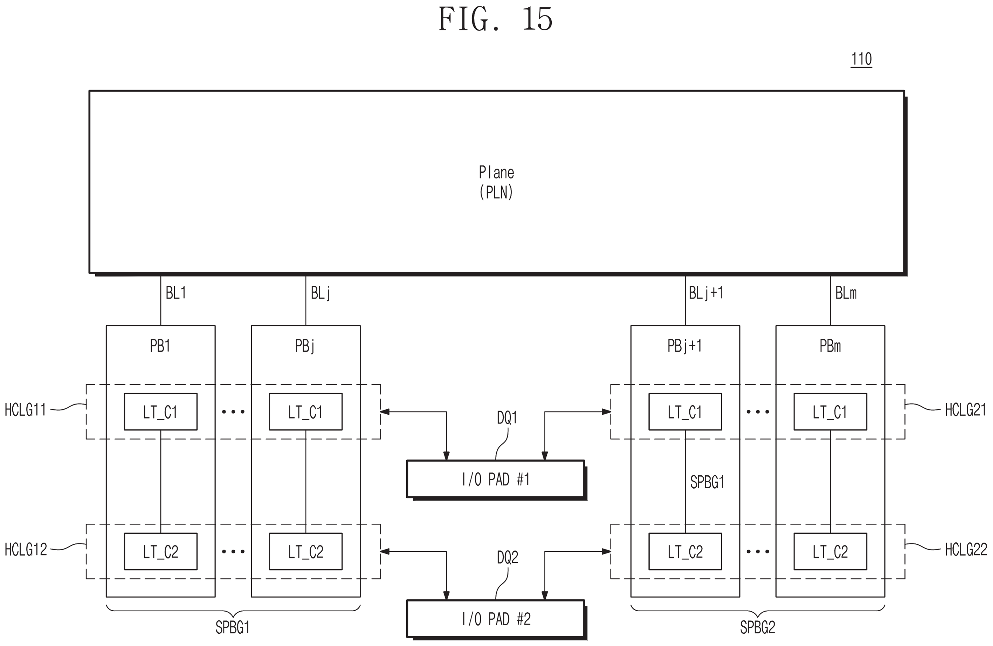

FIG. 15 is a diagram illustrating a correspondence relationship between input/output pads and cache latches in a nonvolatile memory device 110 according to one or more embodiments. FIG. 15 illustrates an example where multiple input/output pads are assigned to a single plane. The nonvolatile memory device of FIG. 15 is similar to the nonvolatile memory devices of FIGS. 11 to 14. Therefore, the same or substantially the same components are denoted by the same or substantially the same reference numerals, and redundant descriptions will be omitted below. An illustrative example is provided for clarity, where the nonvolatile memory device 110 includes two input/output pads DQ1 and DQ2 and each page buffer includes two cache latches LT_C1 and LT_C2.

Referring to FIG. 15, a single plane PLN may be connected to a plurality of page buffers PB1 to PBm through bitlines BL1 to BLm.

The plurality of page buffers PB1 to PBm may be grouped into sub-page buffer groups. For example, some page buffers PB1 to PBj, among the plurality of page buffers PB1 to PBm, may be grouped into a first sub-page buffer group SPBG1, and the remaining page buffers PBj+1 to PBm may be grouped into a second sub-page buffer group SPBG2.

First cache latches LT_C1 of the first sub-page buffer group SPBG1 may form a first half cache latch group HCLG11. The first half cache latch group HCLG11 may be connected to a first input/output pad DQ1.

Second cache latches LT_C2 of the first sub-page buffer group SPBG1 may form a second half cache latch group HCLG12. The second half cache latch group HCLG12 may be connected to a second input/output pad DQ2.

As described above, the first cache latches LT_C1 and the second cache latches LT_C2 corresponding to the first sub-page buffer group SPBG1 may be connected to different input/output pads.

Similarly, first cache latches LT_C1 of the second sub-page buffer group SPBG2 may form a third half cache latch group HCLG21. The third half cache latch group HCLG21 may be connected to the first input/output pad DQ1.

Second cache latches LT_C2 of the second sub-page buffer group SPBG2 may form a fourth half cache latch group HCLG22. The fourth half cache latch group HCLG22 may be connected to the second input/output pad DQ2.

As described above, the first cache latches LT_C1 and the second cache latches LT_C2 corresponding to the second sub-page buffer group SPBG2 may be connected to different input/output pads.

As described in FIG. 15, page buffers corresponding to a single plane may be grouped into different sub-page buffer groups, and each of the sub-page buffer groups may be connected to a plurality of half cache latch groups. In addition, half cache latch groups corresponding to the same sub-page buffer group may be connected to different input/output pads. Accordingly, readout operations and/or write operations on a single plane may be performed in parallel, improving data input/output performance.

### [Specific examples of Command Sets]

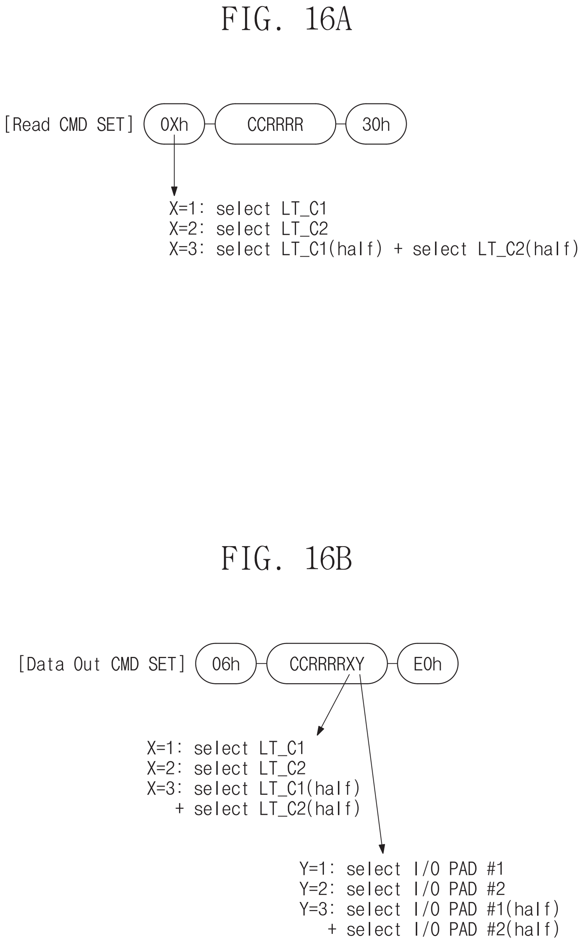

FIGS. 16A and 16B are diagrams illustrating command sets for readout operations in greater detail. FIG. 16A illustrates an example of a read command set Read CMD SET, and FIG. 16B illustrates an example of a data-out command set Data Out CMD SET. In FIGS. 16A and 16B, 'CCRRRR' may represent address information for the target plane.

Referring to FIG. 16A, the read command set Read CMD SET may be configured in the order of command 0Xh, address CCRRRR, and command 30h, where X may correspond to cache address information.

For example, when a value of X is 1, a first cache latch LT_C1 (see FIGS. 11-14) may be selected. For example, during a read operation, data sensed from a target plane may be temporarily stored in a cache latch group (see FIGS. 11-14) including the first cache latches LT_C1.

For example, when the value of X is 2, a second cache latch LT_C2 (see FIGS. 11-14) may be selected. For example, during a read operation, data sensed from the target plane may be temporarily stored in a cache latch group (see FIGS. 11-14) including the second cache latches LT_C2.

For example, when the value of X is 3, both the first cache latch LT_C1 and the second cache latch LT_C2 may be selected. For example, during a read operation, data sensed from a target plane may be temporarily stored in a first half cache latch group (see FIG. 15) including the first cache latches LT_C1 and a second half cache latch group (see FIG. 15) including the second cache latches LT_C2. For example, half of the data may be stored in the first cache latches LT_C1 and half of the data may be stored in the second cache latches LT_C2.

Referring to FIG. 16B, a data-out command set Data Out CMD SET may be configured in the order of command 06h, address CCRRRRXY, and command E0h.

Here, X may correspond to cache address information.

For example, when a value of X is 1, a first cache latch LT_C1 may be selected. For example, during a data-out operation, data stored in a cache latch group including the first cache latches LT_C1 may be transmitted to a selected input/output pad.

For example, when the value of X is 2, a second cache latch LT_C2 may be selected. For example, during a data-out operation, data stored in a cache latch group including the second cache latches LT_C2 may be transmitted to a selected input/output pad.

For example, when the value of X is 3, both the first cache latch LT_C1 and the second cache latch LT_C2 may be selected. For example, during a data-out operation, data temporarily stored in a first half cache latch group including the first cache latches LT_C1 and a second half cache latch group including the second cache latches LT_C2 may be transmitted to a selected input/output pad. Again, in this case, for example, half of a set of data stored in the first cache latches LT_C1 and half of the set of data stored in the second cache latches LT_C2 may be transmitted to a selected input/output pad.

In addition, Y may correspond to input/output pad address information.

For example, when a value of Y is 1, a first input/output pad DQ1 (see FIGS. 11-14) may be selected. For example, during a data-out operation, data stored in the first cache latch group, the second cache latch group, the first half cache latch group, and/or the second half cache latch group may be transmitted to a memory controller 12A (see FIG. 1A) through the first input/output pad DQ1.

For example, when the value of Y is 2, a second input/output pad DQ2 (see FIGS. 11-14) may be selected. For example, during a data-out operation, data stored in the first cache latch group, the second cache latch group, the first half cache latch group, and/or the second half cache latch group may be transmitted to the memory controller 12A through the second input/output pad DQ2.

For example, when the value of Y is 3, both the first input/output pad DQ1 and the second input/output pad DQ2 may be selected. For example, during a data-out operation, a portion of the data stored in the first cache latch group, the second cache latch group, the first half cache latch group, and/or the second half cache latch group may be transmitted to the memory controller 12A through the first input/output pad DQ1, and the remaining data may be transmitted to the memory controller 12A through the second input/output pad DQ2.

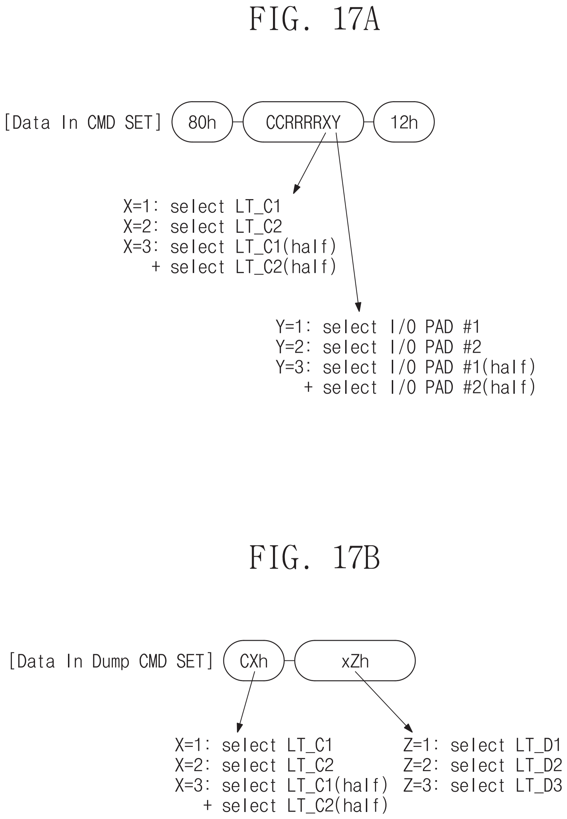

FIGS. 17A and 17B are diagrams illustrating command sets for write operations in greater detail. FIG. 17A illustrates an example of a data-in command set Data In CMD SET, and FIG. 17B illustrates an example of a data-in dump command set Data In Dump CMD SET. In addition, CCRRRR may represent address information for a target plane.

Referring to FIG. 17A, the data-in command set Data In CMD SET may be configured in the order of command 80h, address CCRRRRXY, and command 12h.

Here, X may correspond to cache address information.

For example, when a value of X is 1, a first cache latch LT_C1 (see FIGS. 11-14) may be selected. For example, during a data-in operation, data received from a memory controller 12A (see FIG. 1A) may be temporarily stored in a cache latch group (see FIGS. 11-14) including the first cache latches LT_C1 among cache latches connected to a target plane.

For example, when the value of X is 2, a second cache latch LT_C2 (see FIGS. 11-14) may be selected. For example, during a data-in operation, data received from the memory controller 12A may be temporarily stored in a cache latch group (see FIGS. 11-14) including the second cache latches LT_C2 among the cache latches connected to the target plane.

For example, when the value of X is 3, both the first cache latch LT_C1 and the second cache latch LT_C2 may be selected. For example, during a data-in operation, data received from the memory controller 12A may be temporarily stored in a first half cache latch group (see FIG. 15) including the first cache latches LT_C1 and a second half cache latch group (see FIG. 15) including the second cache latches LT_C2 among the cache latches connected to the target plane.

In addition, Y may correspond to input/output pad address information.

For example, when the value of Y is 1, the first input/output pad DQ1 (see FIGS. 11-14) may be selected. For example, a nonvolatile memory device 11 (see FIG. 1A) may receive data from the memory controller 12A through the first input/output pad DQ1 (see FIGS. 11-14).

For example, when the value of Y is 2, a second input/output pad DQ2 (see FIGS. 11-14) may be selected. For example, the nonvolatile memory device 11 may receive data from the memory controller 12A through the second input/output pad DQ2.

For example, when the value of Y is 3, both the first input/output pad DQ1 and the second input/output pad DQ2 may be selected. For example, the nonvolatile memory device 11 may receive a portion of data to be stored in the target plane from the memory controller 12A through the first input/output pad DQ1 and receive the remaining data from the memory controller 12A through the second input/output pad DQ2.

Referring to FIG. 17B, the data-in dump command set Data In Dump CMD SET may be configured in the order of command CXh and address xZh.

Here, X may correspond to cache address information.

For example, when a value of X is 1, a first cache latch LT_C1 may be selected. For example, during a data-in dump operation, data stored in a cache latch group including the first cache latches LT_C1 may be selected, and the selected data may then be moved to a selected data latch among the data latches LT_D1, LT_D2, and LT_D3 (see FIGS. 10A-10C).

For example, when the value of X is 2, a second cache latch LT_C2 may be selected. For example, during a data-in dump operation, data stored in a cache latch group including the second cache latches LT_C2 may be selected, and the selected data may then be moved to a selected data latch among the data latches LT_D1, LT_D2, and LT_D3.

For example, when the value of X is 3, both the first cache latch LT_C1 and the second cache latch LT_C2 may be selected. For example, during a data-in dump operation, data temporarily stored in a first half cache latch group including the first cache latches LT_C1 and a second half cache latch group including the second cache latches LT_C2 may be selected. The selected data may then be moved to a selected data latch among the data latches LT_D1, LT_D2, and LT_D3.

In addition, Z may correspond to data latch address information.

For example, when a value of Z is 1, a first data latch LT_D1 among the data latches LT_D1, LT_D2, and LT_D3 may be selected. For example, during a data-in dump operation, data stored in a cache latch may be moved to the first data latch LT_D1. For example, the first data latch LT_D1 may temporarily store data to be programmed into a most significant page.

For example, when the value of Z is 2, a second data latch LT_D2 among the data latches LT_D1, LT_D2, and LT_D3 may be selected. For example, during a data-in dump operation, data stored in a cache latch may be moved to the second data latch LT_D2. For example, the second data latch LT_D2 may temporarily store data to be programmed into a middle page.

For example, when the value of Z is 3, a third data latch LT_D3 among the data latches LT_D1, LT_D2, and LT_D3 may be selected. For example, during a data-in dump operation, data stored in a cache latch may be moved to the third data latch LT_D3. For example, the third data latch LT_D3 may temporarily store data to be programmed into a least significant page.

[Specific examples of Performing Readout and Write Operations in Parallel in a Plurality of Planes]

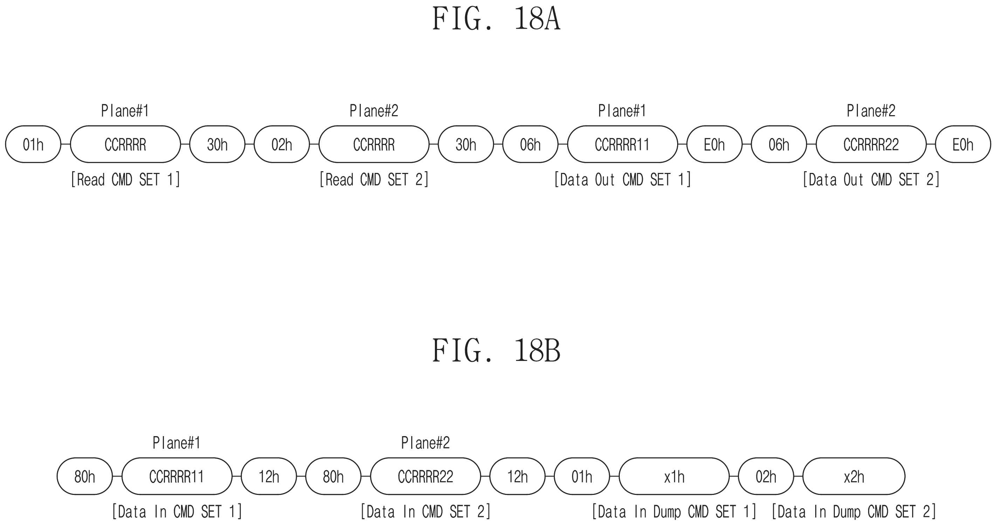

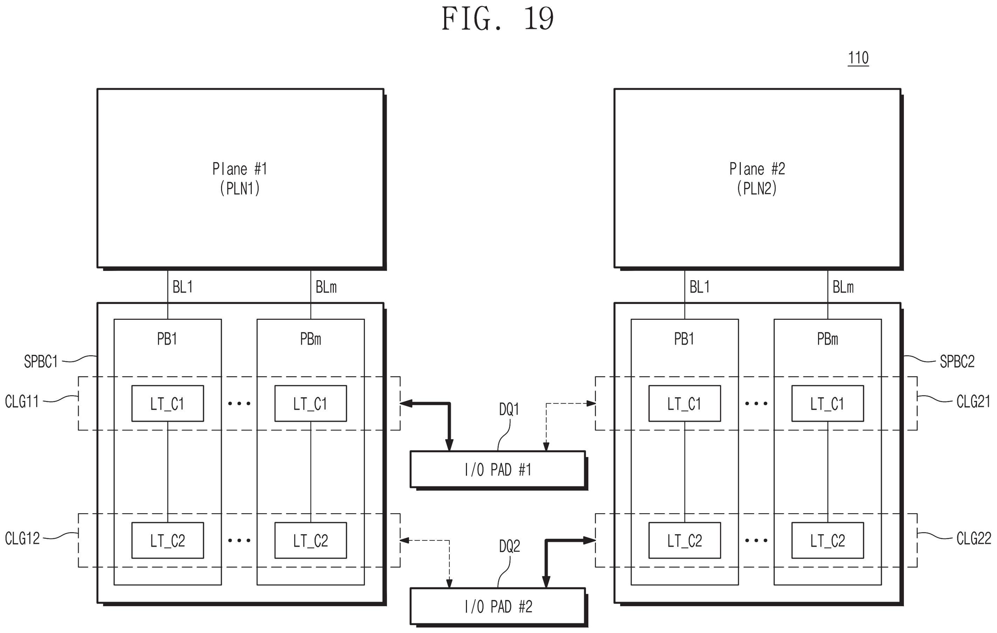

FIGS. 18A, 18B, and 19-21 are diagrams illustrating examples, in which readout operations and/or write operations are performed in parallel, in greater detail. FIG. 18A illustrates an example of a read command set and a data-out command set related to a readout operation. FIG. 18B illustrates an example of a data-in command and a data-in dump command related to a write operation. FIGS. 19-21 illustrate examples of a nonvolatile memory device performing readout operations and/or write operations based on the commands of FIGS. 18A and 18B. In FIGS. 18A, 18B, and 19-21, an illustrative example is provided for clarity, where first and second planes are selected as target planes.

Referring to FIGS. 18A and 19, a nonvolatile memory device 110 may receive command sets for a readout operation. The nonvolatile memory device of FIG. 19 may correspond to the nonvolatile memory device of FIG. 11.

The nonvolatile memory device 110 may receive a first read command set Read CMD SET 1 of '01h,' 'CCRRRR,' and '30h.' A target plane is a first plane PLN1, and a cache latch address (for example, X) is 1. Therefore, data from the first plane PLN1 may be sensed, and the sensed data may be temporarily stored in a first cache latch group CLG11 including first cache latches LT_C1.

Then, the nonvolatile memory device 110 may receive a second read command set Read CMD SET 2 of '02h,' 'CCRRRR,' and '30h.' A target plane is a second plane PLN2, and a cache latch address (for example, X) is 2. Therefore, data from the second plane PLN2 may be sensed, and the sensed data may be temporarily stored in a second cache latch group CLG22 including second cache latches LT_C2.

Then, the nonvolatile memory device 110 may receive a first data-out command set Data Out CMD SET 1 of '06h,' 'CCRRRR11,' and 'E0h.' A target plane is the first plane PLN1, a cache latch address (for example, X) is 1, and an input/output pad address (for example, Y) is 1. Therefore, data stored in a first cache latch group CLG11 of the first plane PLN1 may be transmitted to a first input/output pad DQ1.

Then, the nonvolatile memory device 110 may receive a second data-out command set Data Out CMD SET 2 of '06h,' 'CCRRRR22,' and 'E0h.' A target plane is the second plane PLN2, a cache latch address (for example, X) is 2, and an input/output pad address (for example, Y) is 2. Therefore, data stored in a second cache latch group CLG22 of the second plane PLN2 may be transmitted to a second input/output pad DQ2.

As described above, the data transmission path for the first readout operation corresponding to the first read command set Read CMD SET 1 and the first data-out command set Data Out CMD SET 1 may be distinguished from the data transmission path for the second readout operation corresponding to the second read command set Read CMD SET 2 and the second data-out command set Data Out CMD SET 2. Therefore, the first readout operation and the second readout operation may be performed in parallel (e.g., data read operations can be performed for memory cells of a first plane (e.g., PLN1) at the same time as data read operations are performed for memory cells of a second plane (e.g., PLN2)), improving data input/output performance.

Referring to FIGS. 18B and 19, the nonvolatile memory device 110 may receive command sets for a write operation.

The nonvolatile memory device 110 may receive a first data-in command set Data In CMD SET 1 of '80h,' 'CCRRRR11,' and '12h'. A target plane is a first plane PLN1, a cache latch address (for example, X) is 1, and an input/output pad address (for example, Y) is 1. Therefore, data may be received through the first input/output pad DQ1, and the received data may be temporarily stored in a first cache latch group CLG11 including a first cache latches LT_C1.

Then, the nonvolatile memory device 110 may receive a second data-in command set Data In CMD SET 2 consisting of '80h,' 'CCRRRR22,' and '12h.' A target plane is the second plane PLN2, a cache latch address (for example, X) is 2, and an input/output pad address (for example, Y) is 2. Therefore, data may be received through a second input/output pad DQ2, and the received data may be temporarily stored in a second cache latch group CLG22 including a second cache latches LT_C2.

Then, the nonvolatile memory device 110 may receive a first data-in dump command set Data In Dump CMD SET 1 consisting of '01h' and 'x1h.' A cache latch address (for example, X) is 1, and a data latch address (for example, Z) is 1. Therefore, data stored in the first cache latch group CLG11 may be moved to the first data latch LT_D1. The data stored in the first data latch LT_D1 may be programmed as a most significant page.

Subsequently, the nonvolatile memory device 110 may receive a second data-in dump command set Data In Dump CMD SET 2 of '02h' and 'x2h.' A cache latch address (for example, X) is 2, and a data latch address (for example, Z) is 2. Therefore, data stored in the second cache latch group CLG22 may be moved to the second data latch LT_D2. The data stored in the second data latch LT_D2 may be programmed as a middle page.

As described above, the data transmission path for the first write operation corresponding to the first data-in command set Data In CMD SET 1 and the first data-in dump command set Data In Dump CMD SET 1 may be distinguished from the data transmission path for the second write operation corresponding to the second data-in command set Data In CMD SET 2 and the second data-in dump command set Data In Dump CMD SET 2. Therefore, the first write operation and the second write operation may be performed in parallel (e.g., data can be written to memory cells of a first plane (e.g., PLN1) at the same time as data is written to memory cells of a second plane (e.g., PLN2)), improving data input/output performance.

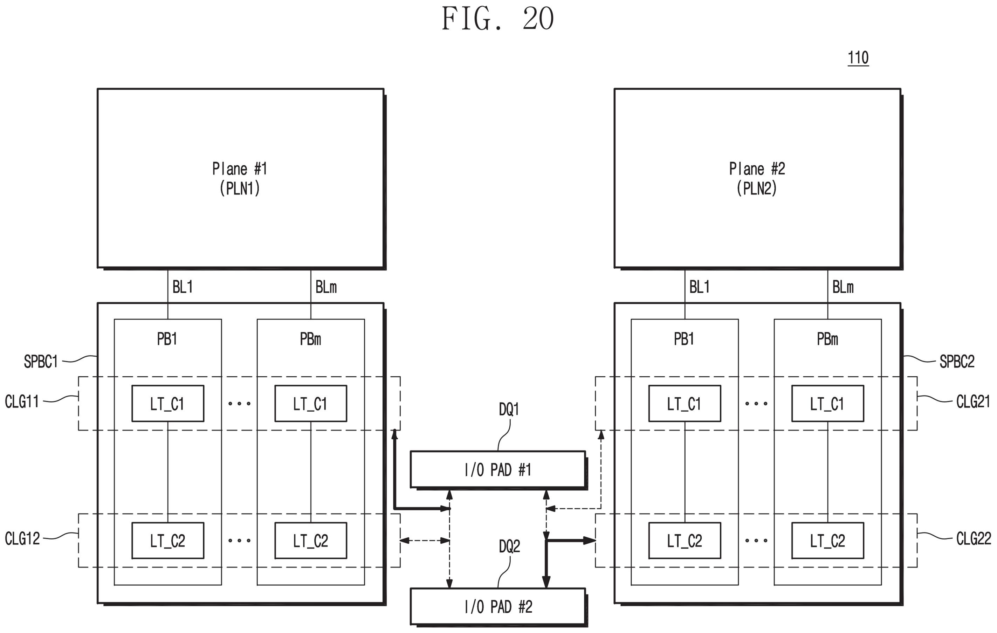

Referring to FIGS. 18A and 20, the nonvolatile memory device 110 may receive command sets for a readout operation. The nonvolatile memory device of FIG. 20 may correspond to the nonvolatile memory device of FIG. 12.

Similarly to FIGS. 18A and 19, a data transmission path for the first readout operation corresponding to the first read command set Read CMD SET 1 and the first data-out command set Data Out CMD SET 1 may be distinguished from a data transmission path for the second readout operation corresponding to the second read command set Read CMD SET 2 and the second data-out command set Data Out CMD SET 2. Therefore, the first readout operation and the second readout operation may be performed in parallel, improving data input/output performance.

Referring to FIGS. 18B and 20, the nonvolatile memory device 110 may receive command sets for a write operation.

Similarly to FIGS. 18B and 19, a data transmission path for the first write operation corresponding to the first data-in command set Data In CMD SET 1 and a first data-in dump command set Data In Dump CMD SET 1 may be formed between the first cache latch group CLG11 and the first input/output pad DQ1.

A data transmission path for the second write operation corresponding to the second data-in command set Data In CMD SET 2 and a second data-in dump command set Data In Dump CMD SET 2 may be formed between the second cache latch group CLG22 and the second input/output pad DQ2.

For example, the data transmission path for the first write operation and the data transmission path for the second write operation may be distinguished from each other. Therefore, the first write operation and the second write operation may be performed in parallel, improving data input/output performance.

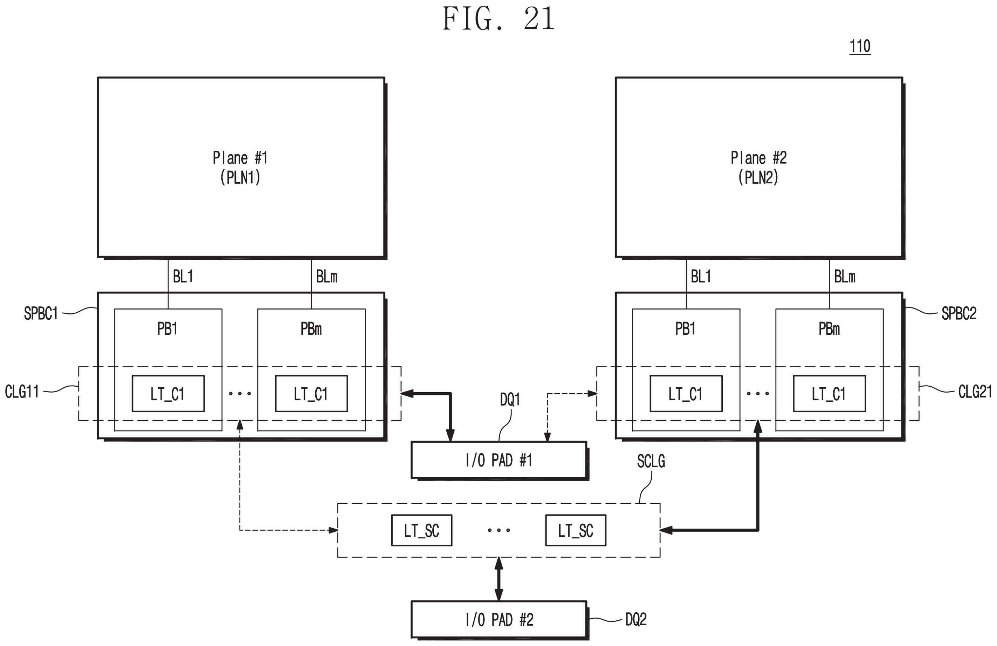

Referring to FIGS. 18A and 21, the nonvolatile memory device 110 may receive command sets for a readout operation. The nonvolatile memory device of FIG. 21 may correspond to the nonvolatile memory device of FIG. 13.

Similarly to FIGS. 18A and 19, a data transmission path for the first readout operation corresponding to the first read command set Read CMD SET 1 and the first data-out command set Data Out CMD SET 1 may be formed between the first cache latch group CLG11 and the first input/output pad DQ1.

A data transmission path for the second readout operation corresponding to the second read command set Read CMD SET 2 and a second data-out command set Data Out CMD SET 2 may be formed between the second cache latch group CLG21 and the shared cache latch group SCLG.

For example, the data transmission path for the first readout operation and the data transmission path for the second readout operation may be distinguished from each other. Therefore, the first readout operation and the second readout operation may be performed in parallel, improving data input/output performance.

Referring to FIGS. 18B and 21, the nonvolatile memory device 110 may receive command sets for a write operation.

Similarly to FIGS. 18B and 19, a data transmission path for the first write operation corresponding to the first data-in command set Data In CMD SET 1 and the first data-in dump command set Data In Dump CMD SET 1 may be formed between the first cache latch group CLG11 and the first input/output pad DQ1.

A data transmission path for the second write operation corresponding to the second data-in command set Data In CMD SET 2 and the second data-in dump command set Data In Dump CMD SET 2 may be formed between the second cache latch group CLG21 and the shared cache latch group SCLG.

For example, the data transmission path for the first write operation and the data transmission path for the second write operation may be distinguished from each other. Therefore, the first write operation and the second write operation may be performed in parallel, improving data input/output performance.

### [Flowcharts of Performing Readout and Write Operations in Parallel in a Plurality of Planes]

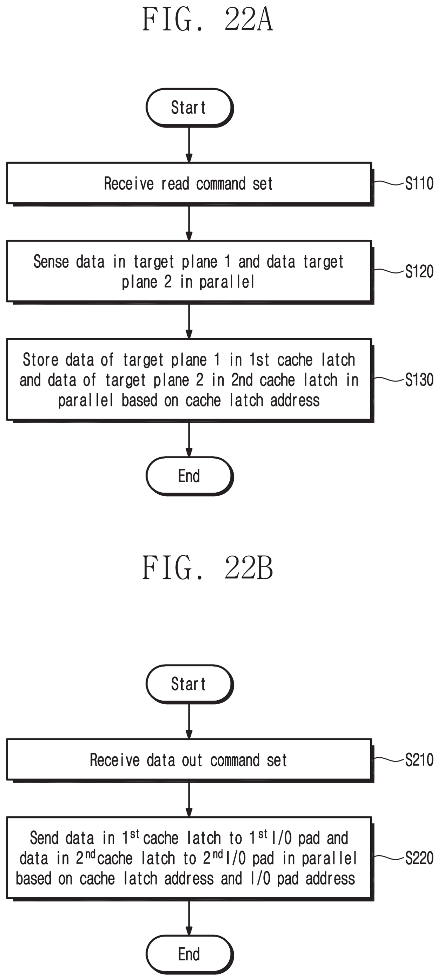

FIGS. 22A and 22B are flowcharts illustrating a readout operation according to one or more embodiments. FIG. 22A is a flowchart illustrating a read operation according to one or more embodiments, and FIG. 22B is a flowchart illustrating a data-out operation according to one or more embodiments. An illustrative example is provided for clarity, where first and second planes are target planes.

Referring to FIG. 22A, in operation S110, the nonvolatile memory device 110 (see FIGS. 19 to 21) may receive a read command set. The read command set may include cache latch address information.

In operation S120, the nonvolatile memory device 110 may perform a sensing operation on data of the first target plane and a sensing operation on data of the second target plane in parallel.

In operation S130, the nonvolatile memory device 110 may store sensed data of the first target plane in a first cache latch and store sensed data of the second target plane in a second cache latch based on the cache latch address information. The storage operation for the first cache latch and the storage operation for the second cache latch may be performed in parallel.

As described above, the read operations may be performed in parallel based on the cache latch address, improving data input/output performance.

Referring to FIG. 22B, in operation S210, the nonvolatile memory device 110 may receive a data-out command set. The data-out command set may include cache latch address information and/or input/output pad address information.

In operation S220, the nonvolatile memory device 110 may transmit data stored in the first cache latch to the first input/output pad and transmit data stored in the second cache latch to the second input/output pad, based on the cache latch address information and/or input/output pad address information. The data-out operation of transmitting data stored in the first cache latch to the first input/output pad and the data-out operation of transmitting data stored in the second cache latch to the second input/output pad may be distinguished from each other. For example, the first readout operation and the second readout operation may be performed in parallel.

As described, the data-out operations may be performed in parallel based on at least one of the cache latch address information or the input/output pad address information, performing data input/output performance.

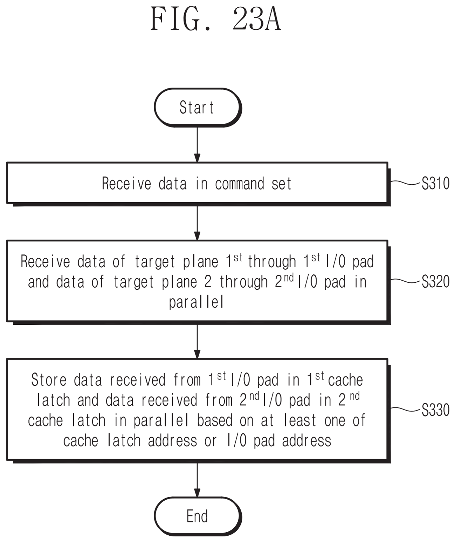

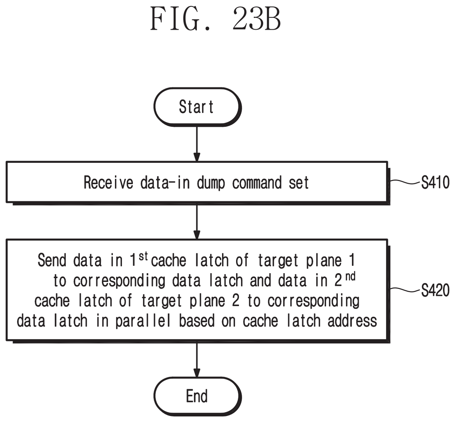

FIGS. 23A and 23B are flowcharts illustrating a write operation according to one or more embodiments. FIG. 23A is a flowchart illustrating a data-in operation according to one or more embodiments, and FIG. 23B is a flowchart illustrating a data-in dump operation according to one or more embodiments. As discussed herein, unless noted otherwise, data-in refers to writing data to a latch (e.g., a cache latch), and data-in dump refers to writing data from one latch (e.g., cache latch) to another latch (e.g., a data latch) and/or a memory cell array. An illustrative example is provided for clarity, where first and second planes are target planes.

Referring to FIG. 23A, in operation S310, the nonvolatile memory device 110 (see FIGS. 19 to 21) may receive a data-in command set. The data-in command set may include at least one of cache latch address information or input/output pad address information.

In operation S320, the nonvolatile memory device 110 may receive data for a first target plane through a first input/output pad and receive data for a second target plane through a second input/output pad. Data reception through the first input/output pad and data reception through the second input/output pad may be performed in parallel.

In operation S330, the nonvolatile memory device 110 may store data received through the first input/output pad in a first cache latch and store data received through the second input/output pad in a second cache latch, based on at least one of the cache latch address information or the input/output pad address information. The operation of storing data in the first cache latch and the operation of storing data in the second cache latch may be performed in parallel.

As described above, the data-in operations may be performed in parallel based on at least one of the cache latch address or the input/output pad address, improving data input/output performance.

Referring to FIG. 23B, in operation S410, the nonvolatile memory device 110 may receive a data-in dump command set. The data-in dump command set may include cache latch address information.

In operation S420, the nonvolatile memory device 110 may transmit the data stored in the first cache latch of the first target plane to a corresponding data latch and transmit the data stored in the second cache latch of the second target plane to a corresponding data latch, based on the cache latch address information. The operation of transmitting data from the first cache latch to the corresponding data latch and the operation of transmitting data from the second cache latch to the corresponding data latch may be performed in parallel.

As described above, the data-in dump operations may be performed in parallel based on the cache latch address, improving data input/output performance.

### [Specific examples of Performing Readout and Write Operations in Parallel in Single Plane]

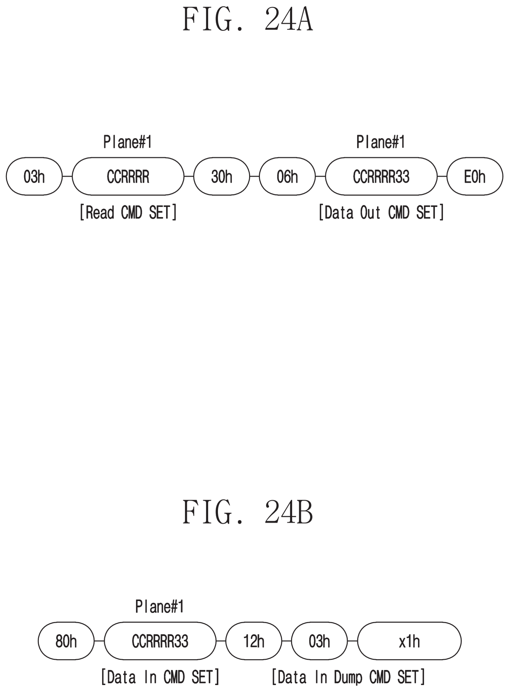

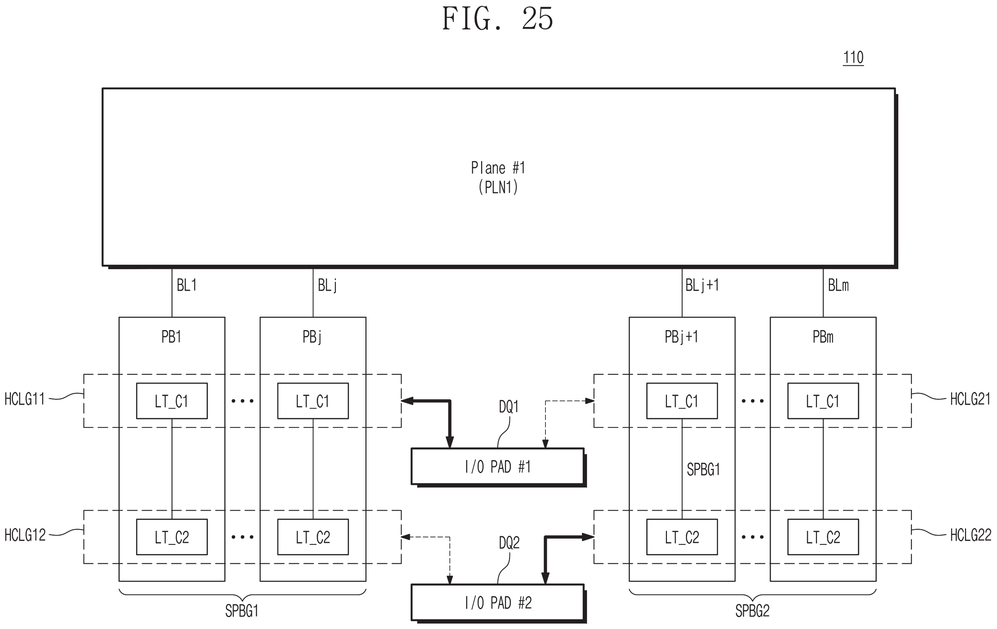

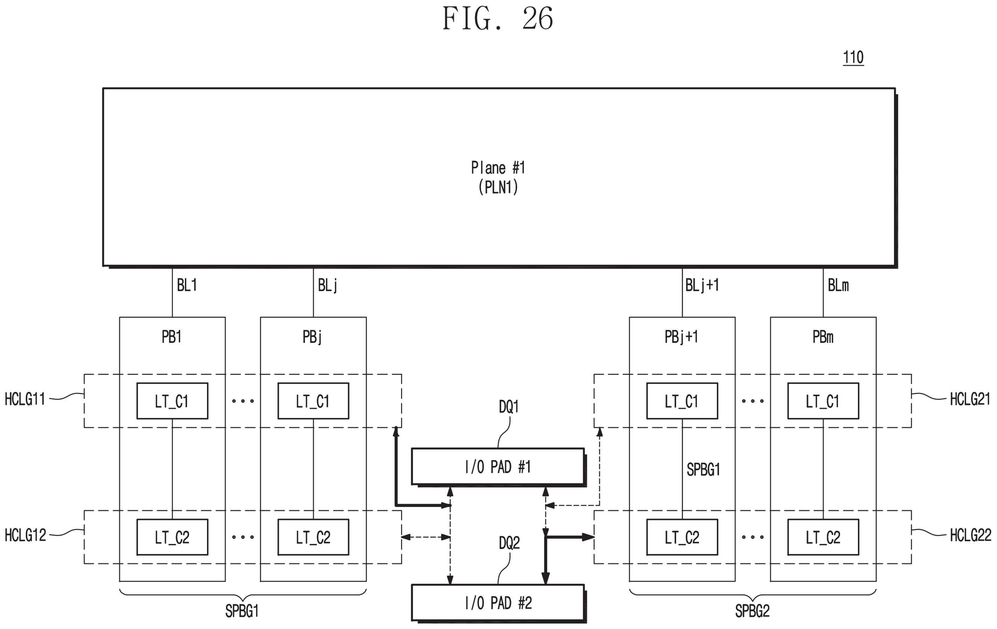

FIGS. 24A, 24B, and 25-26 are diagrams illustrating examples, in which readout operations and/or write operations are performed in parallel, in greater detail. FIG. 24A is a diagram illustrating an example of a read command set and a data-out command set related to a readout operation. FIG. 24B is a diagram illustrating an example of a data-in command and a data-in dump command related to a write operation. FIGS. 25 and 26 are diagrams illustrating examples of a nonvolatile memory device performing readout operations and/or write operations based on the commands of FIGS. 24A and 24B. In FIGS. 24A, 24B, and 25-26, an example is provided for clarity, where a first plane is selected as a target plane.

Referring to FIGS. 24A and 25, the nonvolatile memory device 110 may receive command sets for a readout operation. The nonvolatile memory device of FIG. 25 may correspond to the nonvolatile memory device of FIG. 15.

The nonvolatile memory device 110 may receive a read command set Read CMD SET of '03h,' 'CCRRRR,' and '30h.' A target plane is a first plane PLN1, and a cache latch address (for example, X) is 3.

Therefore, data from the first plane PLN1 may be sensed, and the sensed data may be temporarily stored in a first half cache latch group HCLG11 including first cache latches LT_C1 and a second half cache latch group HCLG22 including second cache latches LT_C2. For example, when a size of the sensed page is 16 kilobytes, 8 kilobytes of data may be stored in the first half cache latch group HCLG11 of the first sub-page buffer group SPBG1, and the remaining 8 kilobytes of data may be stored in the second half cache latch group HCLG22 of the second sub-page buffer group SPBG2.

Then, the nonvolatile memory device 110 may receive a data-out command set Data Out CMD SET of '06h,' 'CCRRRR33,' and 'E0h.' A target plane is the first plane PLN1, a cache latch address (for example, X) is 3, and an input/output pad address (for example, Y) is 3. Therefore, data stored in the first half cache latch group HCLG11 of the first sub-page buffer group SPBG1 may be transmitted to the first input/output pad DQ1, and data stored in the second half cache latch group HCLG22 of the second sub-page buffer group SPBG2 may be transmitted to the second input/output pad DQ2.

As described above, even in a single plane, two data transmission paths may be formed to correspond to the read command set Read CMD SET and the data-out command set Data Out CMD SET, and the two data transmission paths may be distinguished from each other. Therefore, a single readout operation may be performed in parallel, improving data input/output performance.

Referring to FIGS. 24B and 25, the nonvolatile memory device 110 may receive command sets for a write operation.

The nonvolatile memory device 110 may receive a data-in command set Data In CMD SET consisting of '80h,' 'CCRRRR33,' and '12h.' A target plane is the first plane PLN1, a cache latch address (for example, X) is 3, and an input/output pad address (for example, Y) is 3. Therefore, data may be received through the first input/output pad DQ1 and the second input/output pad DQ2. The data received through the first input/output pad DQ1 may be temporarily stored in the first half cache latch group HCLG11 composed of the first cache latches LT_C1, and the data received through the second input/output pad DQ2 may be temporarily stored in the second half cache latch group HCLG22 including second cache latches LT_C2.

For example, when a size of data to be programmed is 16 kilobytes, 8 kilobytes of data may be received through the first input/output pad DQ1 and stored in the first half cache latch group HCLG11 of the first sub-page buffer group SPBG1. The remaining 8 kilobytes of data may be received through the second input/output pad DQ2 and stored in the second half cache latch group HCLG22 of the second sub-page buffer group SPBG2.

Then, the nonvolatile memory device 110 may receive a data-in dump command set Data In Dump CMD SET of '03h' and 'x1h.' A cache latch address (for example, X) is 3, and a data latch address (for example, Z) is 1. Therefore, data stored in the first half cache latch group HCLG11 of the first sub-page buffer group SPBG1 and data stored in the second half cache latch group HCLG22 of the second sub-page buffer group SPBG2 may be moved to the first data latch LT_D1. For example, the data stored in the first data latch LT_D1 may be programmed as a most significant page.

As described above, a data transmission path for the first write operation corresponding to the first data-in command set Data In CMD SET 1 and the first data-in dump command set Data In Dump CMD SET 1 may be distinguished from a data transmission path for the second write operation corresponding to the second data-in command set Data In CMD SET 2 and the second data-in dump command set Data In Dump CMD SET 2. Therefore, the first write operation and the second write operation may be performed in parallel, improving data input/output performance.

As described above, even in a single plane, two data transmission paths may be formed corresponding to the data-in command set Data In CMD SET and the data-in dump command set Data In Dump CMD SET, and these two data transmission paths may be distinguished from each other. Therefore, a single write operation may be performed in parallel, improving data input/output performance.

In FIG. 25, a plurality of input/output pads corresponding to a single plane has been described as being pre-assigned to the first half cache latch group or the second half cache latch group. However, this is an example, and embodiments are not limited thereto.

According to one or more embodiments, as illustrated in FIG. 26, a plurality of input/output pads corresponding to a single plane may be selectively assigned to the first half cache latch group or the second half cache latch group. Even in such a case, two data transmission paths may be formed to correspond to the data-in command set Data In CMD SET and the data-in dump command set Data In Dump CMD SET of FIGS. 24A and 24B, and the two data transmission paths may be distinguished from each other. Therefore, a single write operation may be performed in parallel, improving data input/output performance.

### [Flowcharts of Performing Readout and Write Operations in Parallel in Single Plane]

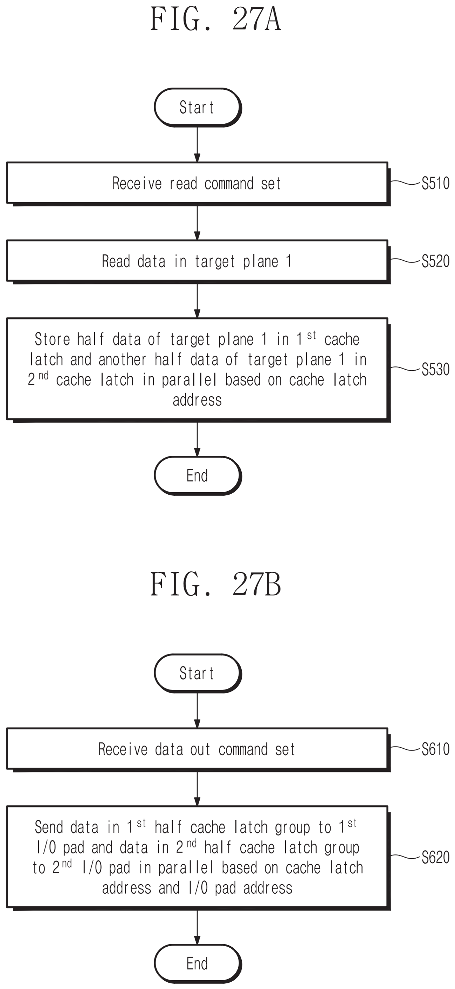

FIGS. 27A and 27B are flowcharts illustrating a readout operation in a single plane according to one or more embodiments. FIG. 27A is a flowchart illustrating a read operation in a single plane according to one or more embodiments. FIG. 27B is a flowchart illustrating a data-out operation in a single plane according to one or more embodiments. An illustrative example is provided for clarity, where the first plane is a target plane.

Referring to FIG. 27A, in operation S510, the nonvolatile memory device 110 (see FIGS. 25 and 26) may receive a read command set. The read command set may include cache latch address information.

In operation S520, the nonvolatile memory device 110 may perform a sensing operation on data of the first target plane.

In operation S530, the nonvolatile memory device 110 may store a portion of the sensed data of the first target plane in a half cache latch group including first cache latches and store the remaining sensed data of the first target plane in a half cache latch group including second cache latches, based on the cache latch address information. The storage operation for the first half cache latch group and the storage operation for the second half cache latch group may be performed in parallel.

As described above, even in a single plane, a readout operation may be performed in parallel based on the cache latch address, improving data input/output performance.

Referring to FIG. 27B, in operation S610, the nonvolatile memory device 110 may receive a data-out command set. The data-out command set may include cache latch address information and/or input/output pad address information.

In operation S620, the nonvolatile memory device 110 may transmit data stored in a first half cache latch group to the first input/output pad and transmit data stored in a second half cache latch group to the second input/output pad, based on the cache latch address information and/or input/output pad address information. The data-out operation of transmitting data stored in the first half cache latch group to the first input/output pad and the data-out operation of transmitting data stored in the second half cache latch group to the second input/output pad may be performed in parallel.

As described above, even in a single plane, the data-out operation may be performed in parallel based on at least one of the cache latch address information or the input/output pad address information, improving data input/output performance.

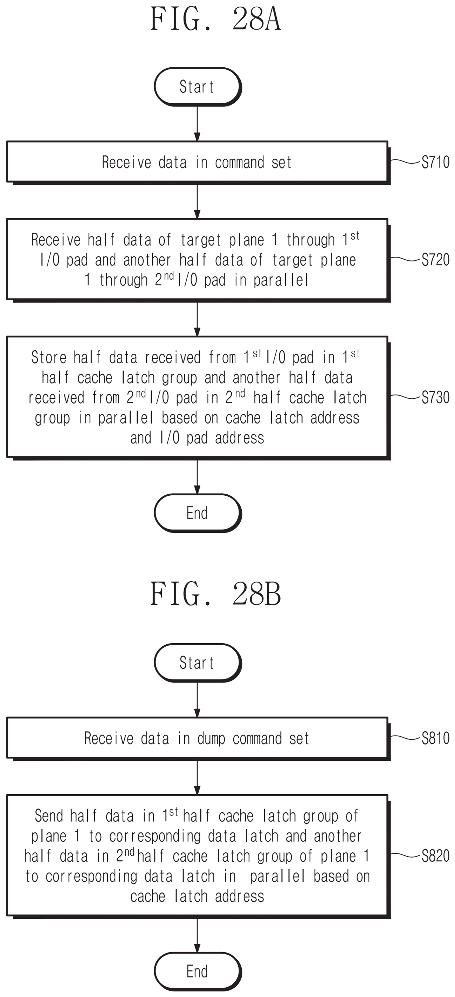

FIGS. 28A and 28B are flowcharts illustrating a write operation in a single plane according to one or more embodiments. FIG. 28A is a flowchart illustrating a data-in operation in a single plane according to one or more embodiments. FIG. 28B is a flowchart illustrating a data-in dump operation in a single plane according to one or more embodiments. An illustrative example is provided for clarity, where the first plane is a target plane.

Referring to FIG. 28A, in operation S710, the nonvolatile memory device 110 (see FIGS. 25 and 26) may receive a data-in command set. The data-in command set may include at least one of cache latch address information or input/output pad address information.

In operation S720, the nonvolatile memory device 110 may receive a portion of the data to be programmed into the first target plane through the first input/output pad and receive the remaining data to be programmed into the first target plane through the second input/output pad. Data reception through the first input/output pad and data reception through the second input/output pad may be performed in parallel.

In operation S730, the nonvolatile memory device 110 may store the portion of data received through the first input/output pad in the first half cache latch group and store the remaining data received through the second input/output pad in the second half cache latch group, based on at least one of the cache latch address information or the input/output pad address information. The operation of storing data in the first half cache latch group and the operation of storing data in the second half cache latch group may be performed in parallel.

As described above, even within a single plane, the data-in operation may be performed in parallel based on at least one of the cache latch address or the input/output pad address, improving data input/output performance.

Referring to FIG. 28B, in operation S810, the nonvolatile memory device 110 may receive a data-in dump command set. The data-in dump command set may include cache latch address information.

In operation S820, the nonvolatile memory device 110 may transmit a portion of the data stored in the first half cache latch group of the first target plane to a corresponding data latch and transmit the remaining data stored in the second half cache latch group of the first target plane to a corresponding data latch, based on the cache latch address information. The operation of transmitting data from the first half cache latch group to the corresponding data latch and the operation of transmitting data from the second half cache latch group to the corresponding data latch may be performed in parallel.

As described above, even within a single plane, the data-in dump operation may be performed in parallel based on the cache latch address, improving data input/output performance.

### [Specific Examples in which Core Operations Overlaps Data-out Operation or Data-in operation]

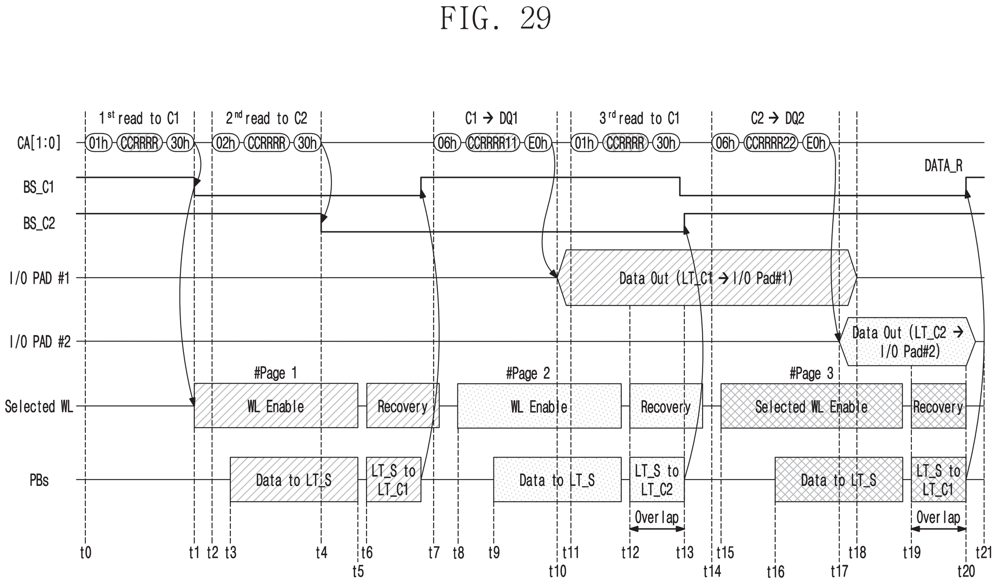

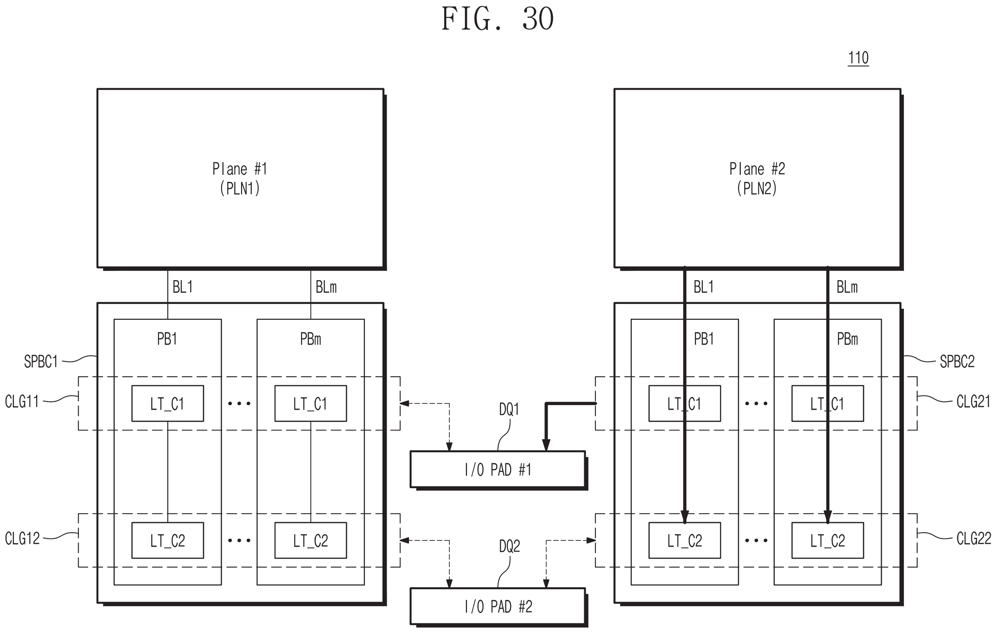

FIGS. 29 and 30 are diagrams illustrating an example, in which a core operation is performed during a data-out operation, in greater detail. FIG. 29 illustrates an example of a timing diagram in which a data-out operation and an operation of storing data in a cache latch are performed in an overlapping manner. FIG. 30 illustrates an example of a nonvolatile memory device according to one or more embodiments that may perform a data-out operation and an operation of storing data in a cache latch in an overlapping manner.

An illustrative example is provided for clarity, where the nonvolatile memory device of FIG. 30 is the same as the nonvolatile memory device of FIG. 11 or FIG. 19. Therefore, the same or substantially the same components are denoted by the same or substantially the same reference numerals, and redundant descriptions will be omitted below. An illustrative example is provided for clarity, where a second plane is a target plane, and a readout operation is performed on three pages corresponding to the same wordline.

Referring to FIGS. 29 and 30, during a time period from a zeroth time point t0 to a first time point t1, a first read command set may be received through a CA pads CA[1:0]. The cache latch address is 1, so that data of a first page of a second plane PLN2 may be requested to be stored in a first cache latch group CLG21 including first cache latches LT_C1.

During a time period from the first time point t1 to a fifth time point t5, a wordline selected by a first read command set may be activated.

At the first time point t1, a busy signal BS_C1 of first cache latches LT_C1 of a second sub-page buffer circuit SPBC2 corresponding to the first read command set may transition from high to low.

During a time period from a second time point t2 to the fourth time point t4, a second read command set may be received. The cache latch address is 2, so that data of the second plane PLN2 be stored in a second cache latch group CLG22 including second cache latches LT_C2.

During a time period between a third time point t3 and a fifth time point t5, a sensing operation on data of the first page of a selected wordline corresponding to the first read command set may be performed, and the sensed data may be stored in sensing latches LT_S.

At the fourth time point t4, a busy signal BS_C2 of the second cache latches LT_C2 of the second sub-page buffer circuit SPBC2 corresponding to the second read command set may transition from high to low.

During a time period from a sixth time point t6 to a seventh time point t7, data from the sensing latches LT_S corresponding to the first read command set may be moved to the first cache latch group CLG21 including the first cache latches LT_C1.

During a time period from the sixth time point t6 to an eighth time point t8, a recovery operation on the first page of the selected wordline may be performed.

During a time period from a seventh time point t7 to a tenth time point t10, a first data-out command set may be received through the CA pads CA[1:0]. Both the cache latch address and the input/output pad address are 1, data stored in the first cache latch group CLG21 of the second plane PLN2 may be requested to be output through a first input/output pad DQ1.

During a time period from the eighth time point t8 to a twelfth time point t12, the wordline selected by the second read command set may be activated.

During a time period from a ninth time point t9 to the twelfth time point t12, a sensing operation on data of the second page of the selected wordline corresponding to the second read command set may be performed, and the sensed data may be stored in the sensing latches LT_S.

During a time period from a tenth time point t10 to an eighteenth time point t18, data stored in the first cache latch group CLG21 may be transmitted to the memory controller through the first input/output pad DQ1 in response to the first data-out command set.

During a time period from the eleventh time point t11 to a thirteenth time point t13, a third read command set may be received through the CA pads CA[1:0]. The cache latch address is 1, so that data of the third page of the second plane PLN2 may be requested to be stored in the first cache latch group CLG21 including the first cache latches LT_C1.

During a time period from the twelfth time point t12 to the thirteenth time point t13, data from the sensing latches LT_S corresponding to the second read command set may be moved to the second cache latch group CLG22 including the second cache latches LT_C2.

During a time period from the twelfth time point t12 to a fourteenth time point t14, a recovery operation on a second page of the selected wordline may be performed.

During a time period from the fourteenth time point t14 to a seventeenth time point t17, a second data-out command set may be received through the CA pads CA[1:0]. The cache latch address and the input/output pad address are both 2, so that data stored in the second cache latch group CLG22 of the second plane PLN2 may be required to be output through the second input/output pad DQ2.

During a time period from a fifteenth time point t15 to a nineteenth time point t19, the wordline selected by the third read command set may be activated.

During a time period from a sixteenth time point t16 to the nineteenth time point t19, a sensing operation on data of the third page of the selected wordline corresponding to the third read command set may be performed, and the sensed data may be stored in the sensing latches LT_S.

During a time period from the seventeenth time point t17 to a twenty-first time point t21, data stored in the second cache latch group CLG22 may be transmitted to the memory controller through the second input/output pad DQ2 in response to the second data-out command set.

During a time period from the nineteenth time point t19 to a twentieth time point t20, data from the sensing latches LT_S corresponding to the third read command set may be moved to the first cache latch group CLG21 including the first cache latches LT_C1.

During a time period from the nineteenth time point t19 to the twentieth time point t20, a recovery operation on a third page of the selected wordline may be performed.

In such a manner, readout operations may be performed based on a plurality of read command sets and a plurality of data-out commands.

The data-out operation, in which data is transmitted to the memory controller through the input/output pad, and the operation of transmitting sensed data to the cache latch within the page buffer may overlap each other.

For example, referring to a time period from the twelfth time point t12 to the thirteenth time point t13 in FIG. 29, and FIG. 30, sensed data may be moved to the second cache latch group CLG22 including the second cache latches LT_C2 of the second sub-page buffer circuit SPBC2 while data from the first cache latch group CLG21 including the first cache latches LT_C1 of the second sub-page buffer circuit SPBC2 is transmitted to the memory controller through the first input/output pad DQ1.

In addition, for example, referring to the nineteenth time point t19 to the twentieth time point t20, sensed data may be moved to the first cache latch group CLG21 including the first cache latches LT_C1 of the second sub-page buffer circuit SPBC2 while data from the second cache latch group CLG22 including the second cache latches LT_C2 of the second sub-page buffer circuit SPBC2 is transmitted to the memory controller through the second input/output pad DQ2.

In a typical page buffer, only one cache latch is provided per page buffer, so that a core operation and a data-out operation of the same page buffer cannot be performed simultaneously. In contrast, the page buffer according to one or more embodiments includes a plurality of cache latches, so that a core operation and a data-out operation of the same page buffer may be performed simultaneously. Therefore, data input/output performance may be further improved.

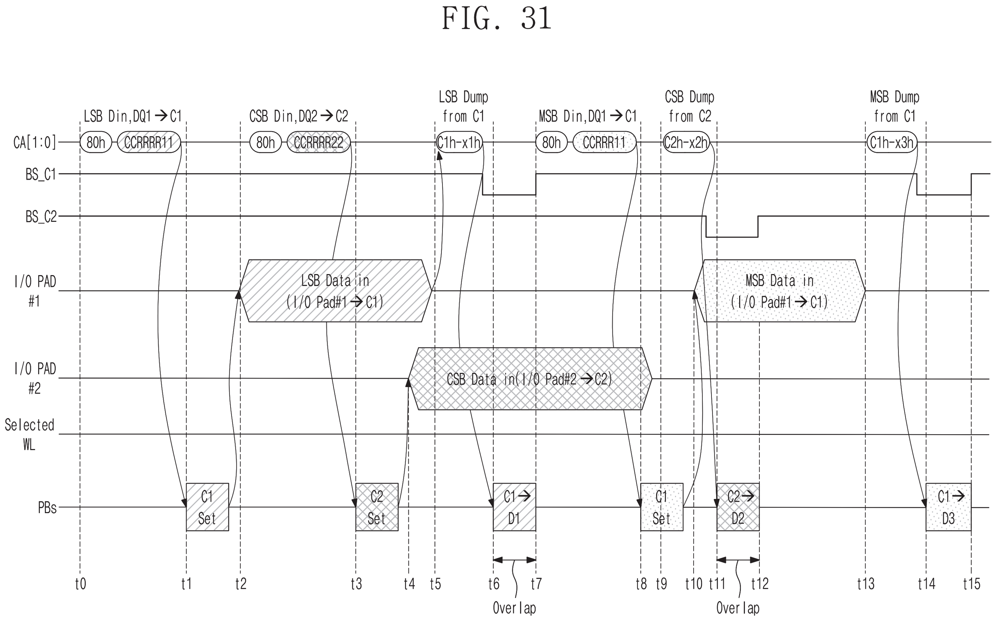

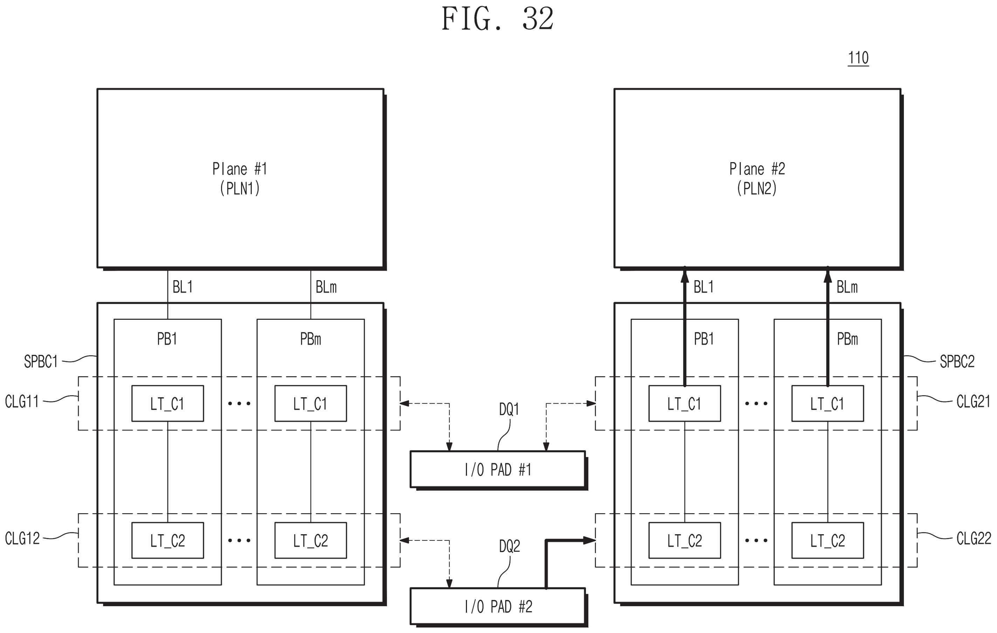

FIGS. 31 and 32 are diagrams illustrating an example, in which a core operation is performed during a data-in operation, in greater detail. FIG. 31 is a diagram illustrating an example of a timing diagram in which a data-in operation and an operation of transmitting data from a cache latch to a data latch are performed in an overlapping manner. FIG. 32 is a diagram illustrating an example of a nonvolatile memory device according to one or more embodiments that may perform a data-in operation and an operation of transmitting data from a cache latch to a data latch in an overlapping manner.

An illustrative example is provided for clarity, where the nonvolatile memory device of FIG. 32 is the same as the nonvolatile memory device of FIG. 11 or FIG. 19. Therefore, the same or substantially the same components are denoted by the same or substantially the same reference numerals, and redundant descriptions will be omitted below. In addition, an illustrative example is provided, where a second plane is a target plane and a write operation is performed on three pages corresponding to the same wordline.

Referring to FIGS. 31 and 32, during a time period from a zeroth time point t0 to a first time point t1, a first data-in command set may be received through CA pads CA[1:0]. A cache latch address and an input/output pad address are both 1, so that data received through the first input/output pad DQ1 may be requested to be stored in a first cache latch group CLG21 including first cache latches LT_C1.

During a time period from the first time point t1 to a second time point t2, a setting operation on the first cache latches LT_C1 of the first cache latch group CLG21 may be performed in response to the first data-in command set. For example, the first cache latches LT_C1 of the first cache latch group CLG21 may be initialized.

During a time period from the second time point t2 to a fifth time point t5, data may be received through the first input/output pad DQ1 in response to the first data-in command set, and the received data may be temporarily stored in the first cache latch group CLG21 including the first cache latches LT_C1.

During a time period from the second time point t2 to a third time point t3, a second data-in command set may be received through a CA pads CA[1:0]. A cache latch address and an input/output pad address are both 2, data received through the second input/output pad DQ2 may be requested to be stored in a second cache latch group CLG22 including second cache latches LT_C2.

During a time period from the third time point t3 to a fourth time point t4, a setting operation on a second read command set for the second cache latches LT_C2 of the second cache latch group CLG22 may be performed in response to the second data-in command set.

During a time period from the fourth time point t4 to a ninth time point t9, data may be received through the second cache line in response to the second data-in command set, and the received data may be temporarily stored in the second cache latch group CLG22 including the second cache latches LT_C2.

During a time period from a fifth time point t5 to a sixth time point t6, a first data-in dump command set may be received through the CA pads CA[1:0]. The cache latch address and the data latch address are both 1, so that data from the first cache latch group CLG21 including the first cache latches LT_C1 may be requested to be moved to the first data latch LT_D1.

During a time period from the sixth time point t6 to a seventh time point t7, data stored in the first cache latches LT_C1 of the first cache latch group CLG21 of a second sub-page buffer circuit SPBC2 may be moved to the first data latches LT_D1 in response to the first data-in dump command set.

During a time period from the seventh time point t7 to an eighth time point t8, a third data-in command set may be received through the CA pads CA[1:0]. The cache latch address and the input/output pad address are both 1, so that data received through the first input/output pad DQ1 may be requested to be stored in the first cache latch group CLG21 including the first cache latches LT_C1.

During a time period from the eighth time point t8 to a tenth time point t10, a setting operation on the first cache latches LT_C1 of the first cache latch group CLG21 may be performed in response to the third data-in command set.

During a time period from the ninth time point t9 to an eleventh time point t11, a second data-in dump command set may be received through the CA pads CA[1:0]. The cache latch address and the data latch address are both 2, data from the second cache latch group CLG22 including the second cache latches LT_C2 may be requested to be moved to the second data latch LT_D2.

During a time period from the tenth time point t10 to a thirteenth time point t13, data may be received through the first input/output pad DQ1 in response to the third data-in command set, and the received data may be temporarily stored in the first cache latch group CLG21 including the first cache latches LT_C1.

During a time period from the eleventh time point t11 to the twelfth time point t12, data stored in the second cache latches LT_C2 of the second cache latch group CLG22 of the second sub-page buffer circuit SPBC2 may be moved to the second data latches LT_D2 in response to the second data-in dump command set.

During a time period from a thirteenth time point t13 to a fourteenth time point t14, a third data-in dump command set may be received through the CA pads CA[1:0]. The cache latch address and the data latch address are 1 and 3, respectively, so that data from the first cache latch group CLG21 including the first cache latches LT_C1 may be requested to be moved to a third data latch LT_D3.

During a time period from the fourteenth time point t14 to a fifteenth time point t15, data stored in the first cache latches LT_C1 of the first cache latch group CLG21 of the second sub-page buffer circuit SPBC2 may be moved to the third data latches LT_D3 in response to the third data-in dump command set.

In such a manner, write operations may be performed based on a plurality of data-in command sets and a plurality of data-in dump commands.

The data-in operation, in which data is received from the memory controller through the input/output pad, and the operation of moving data from the cache latch to the data latch within the page buffer may overlap each other.

For example, referring to the time period from the sixth time point t6 to the seventh time point t7 in FIG. 31, and FIG. 32, data stored in the first cache latches LT_C1 of the first cache latch group CLG21 of the second sub-page buffer circuit SPBC2 may be moved to the first data latches LT_D1 while data received through the second input/output pad DQ2 is stored in the second cache latch group CLG22 of the second sub-page buffer circuit SPBC2.

In addition, for example, referring to the time period from the eleventh time point t11 to the twelfth time point t12, data stored in the second cache latches LT_C2 of the second cache latch group CLG22 of the second sub-page buffer circuit SPBC2 may be moved to the second data latches LT_D2 while data received through the first input/output pad DQ1 is stored in the first cache latch group CLG21 of the second sub-page buffer circuit SPBC2.

In a typical page buffer, only one cache latch is provided per page buffer, so that a core operation and a data-out operation of the same page buffer cannot be performed simultaneously. In contrast, the page buffer according to one or more embodiments includes a plurality of cache latches, so that a core operation and a data-out operation of the same page buffer may be performed simultaneously. Therefore, data input/output performance may be further improved.

For clarity, in FIGS. 29 to 32, the descriptions have been provided based on the configuration of the nonvolatile memory of FIG. 11. However, this is an example, and it will be understood that embodiments may be applied to various nonvolatile memory devices described herein.

As set forth above, according to embodiments, a nonvolatile memory device may provide improved data input/output performance.

## Claims

1. A nonvolatile memory device (11A; 11B; 110A; 110B; 110) comprising:
a memory cell array (111) comprising a plurality of planes (PLN1-PLNn);
a page buffer circuit (115) connected to the memory cell array (111) through a plurality of bitlines (BL) and comprising at least one cache latch (LT_C); and
a plurality of input/output pads (DQ1-DQk) connected to the page buffer circuit (115) through a plurality of data lines and configured to transmit data to and receive data from a memory controller (12A; 12B; 120A; 120B),
wherein:
a command set comprises at least one of cache latch address information or input/output pad address information; and
the nonvolatile memory device (11A; 11B; 110A; 110B; 110) is configured to perform a readout operation or a write operation based on at least one of the cache latch address information or the input/output pad address information included in the command set.

2. The nonvolatile memory device (11B; 110B; 110) of claim 1, further comprising:
at least one command address pad (CAQ1-CAQi) configured to receive the cache latch address information or the input/output pad address information included in the command set.

3. The nonvolatile memory device (11A; 11B; 110A; 110B; 110) of claim 1 or 2, wherein:
the page buffer circuit (115) comprises a plurality of page buffers (PB1-PBm) corresponding to the plurality of bitlines (BL); and
each of the plurality of page buffers (PB1-PBm) comprises:
a first cache latch (LT_C1) connected to a first data line among the plurality of data lines; and
a second cache latch (LT_C2) connected to a second data line among the plurality of data lines.

4. The nonvolatile memory device (11A; 11B; 110A; 110B; 110) of claim 3, wherein:
the plurality of input/output pads (DQ1-DQk) comprise a first input/output pad (DQ1) and a second input/output pad (DQ2);
the first input/output pad (DQ1) corresponds to the first cache latch (LT_C1) included in each of the plurality of page buffers (PB1-PBm); and
the second input/output pad (DQ2) corresponds to the second cache latch (LT_C2) included in each of the plurality of page buffers (PB1-PBm).

5. The nonvolatile memory device (11A; 11B; 110A; 110B; 110) of claim 4, wherein the plurality of planes (PLN1-PLNn) comprise a first plane (PLN1) and a second plane (PLNn), the nonvolatile memory device (11A; 11B; 110A; 110B) configured such that:
during the readout operation, the first input/output pad (DQ1) receives data from the first cache latch (LT_C1) included in page buffers corresponding to the first plane (PLN1) among the plurality of page buffers (PB1-PBm), and the second input/output pad (DQ2) receives data from the second cache latch (LTC2) included in page buffers corresponding to the second plane (PLNn) among the plurality of page buffers (PB1-PBm); and
during the write operation, the first input/output pad (DQ1) transmits data to the first cache latch (LTC1) included in the page buffers corresponding to the first plane (PLN1) among the plurality of page buffers (PB1-PBm), and the second input/output pad (DQ2) transmits data to the second cache latch (LT_C2) included in the page buffers corresponding to the second plane (PLNn) among the plurality of page buffers (PB1-PBm).

6. The nonvolatile memory device (11A; 11B; 110A; 110B; 110) of claim 3, wherein:
the plurality of input/output pads (DQ1-DQk) comprise a first input/output pad (DQ1) and a second input/output pad (DQ2); and
each of the first input/output pad (DQ1) and the second input/output pad (DQ2) selectively corresponds to one of the first cache latch (LT_C1) and the second cache latch (LT_C2) included in each of the plurality of page buffers (PB1-PBm).

7. The nonvolatile memory device (11A; 11B; 110A; 110B; 110) of claim 6, configured such that:
during the readout operation or the write operation, the first input/output pad (DQ1) and the second input/output pad (DQ2) correspond to different planes, respectively.

8. The nonvolatile memory device (11A; 11B; 110A; 110B; 110) of claim 7, wherein:
the plurality of planes (PLN1-PLNn) comprise a first plane (PLN1) and a second plane (PLNn); and configured such that:
during the readout operation or the write operation, the first input/output pad (DQ1) is connected to the first cache latches (LT_C1) included in page buffers corresponding to the first plane (PLN1) among the plurality of page buffers (PB1-PBm), and the second input/output pad (DQ2) is connected to the second cache latches (LT_C2) included in page buffers corresponding to the second plane (PLNn) among the plurality of page buffers (PB1-PBm).

9. The nonvolatile memory device (11A; 11B; 110A; 110B; 110) of claim 1 or 2, further comprising:
a shared cache latch (LT_SC) connected to one of the plurality of data lines.

10. The nonvolatile memory device (11A; 11B; 110A; 110B; 110) of claim 9, wherein:
the page buffer circuit (115) comprises:
a first page buffer (PB1) corresponding to a first bitline (BL1) among the plurality of bitlines (BL); and
a second page buffer (PB2) corresponding to a second bitline (BL2) among the plurality of bitlines (BL);
the first page buffer (PB1) comprises a first cache latch (LT_Ca) connected to a first data line among the plurality of data lines;
the second page buffer (PB2) comprises a second cache latch (LT_Cb) connected to a second data line among the plurality of data lines; and
the first page buffer (PB1) and the second page buffer (PB2) are selectively connected to the shared cache latch (LT_SC) based on the cache latch address.

11. The nonvolatile memory device (11A; 11B; 110A; 110B; 110) of claim 10, wherein:
the plurality of input/output pads (DQ1-DQk) comprise a first input/output pad (DQ1) and a second input/output pad (DQ2);
the first input/output pad (DQ1) corresponds to the first cache latch included in the first page buffer and a second cache latch included in the second page buffer; and
the second input/output pad (DQ2) corresponds to the shared cache latch.

12. The nonvolatile memory device (11A; 11B; 110A; 110B; 110) of claim 10, wherein:
the plurality of planes (PLN1-PLNn) comprise a first plane (PLN1) and a second plane (PLNn);
the first page buffer corresponds to the first plane (PLN1), and the second page buffer corresponds to the second plane (PLNn); and
during the readout operation or the write operation, a first input/output pad (DQ1) transmits data to and receives data from the first cache latch included in the first page buffer, and a second input/output pad (DQ2) transmits data to and receives data from the shared cache latch connected to the second page buffer.

13. The nonvolatile memory device (11A; 11B; 110A; 110B; 110) of claim 1 or 2, wherein:
the plurality of input/output pads (DQ1-DQk) comprise a first input/output pad (DQ1) and a second input/output pad (DQ2);
the first input/output pad (DQ1) corresponds to planes included in a first plane group (PG1) among the plurality of planes (PLN1-PLNn); and
the second input/output pad (DQ2) corresponds to planes (PLNa+1 included in a second plane group (PG2) among the plurality of planes (PLN1-PLNn).

14. The nonvolatile memory device (11A; 11B; 110A; 110B; 110) of claim 1 or 2, wherein:
the page buffer circuit (115) comprises a first sub-page buffer group (SPBG1) and a second sub-page buffer group (SPBG2);
the first sub-page buffer group (SPBG1) and the second sub-page buffer group (SPBG2) correspond to the same plane among the plurality of planes (PLN1-PLNn) and each comprise a plurality of page buffers (PB1-PBm);
each of the page buffers included in the first sub-page buffer group (SPBG1) comprises:
a first cache latch; and
a second cache latch connected to a data line different from a data line of the first cache latch; and
each of the page buffers included in the second sub-page buffer group (SPBG2) comprises:
a third cache latch; and
a fourth cache latch connected to a data line different from a data line of the third cache latch.

15. The nonvolatile memory device (11A; 11B; 110A; 110B; 110) of claim 14, wherein:
the plurality of input/output pads (DQ1-DQk) comprise a first input/output pad (DQ1) and a second input/output pad (DQ2);
the first input/output pad (DQ1) corresponds to the first cache latch included in the first sub-page buffer group (SPBG1) and the third cache latch included in the second sub-page buffer group (SPBG2); and
the second input/output pad (DQ2) corresponds to the second cache latch included in the first sub-page buffer group (SPBG1) and the fourth cache latch included in the second sub-page buffer group (SPBG2).
